(19) Europäisches Patentamt
European Patent Office
Office européen des brevets

(11) **EP 4 512 776 A1**

(12) **EUROPEAN PATENT APPLICATION**
published in accordance with Art. 153(4) EPC

(43) Date of publication:
**26.02.2025 Bulletin 2025/09**

(21) Application number: 23791890.9

(22) Date of filing: **19.04.2023**

(51) International Patent Classification (IPC):
**C01G 33/00** (2006.01)     **C01G 35/00** (2006.01)

(52) Cooperative Patent Classification (CPC):
**C01G 33/00; C01G 35/00**

(86) International application number:
**PCT/JP2023/015590**

(87) International publication number:
**WO 2023/204242 (26.10.2023 Gazette 2023/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **21.04.2022  JP 2022070229**

(71) Applicant: DIC Corporation
**Tokyo 174-8520 (JP)**

(72) Inventors:
• **YUAN Jianjun**
**Sakura-shi, Chiba 285-8668 (JP)**

• **ARAKAWA Takami**
**Sakura-shi, Chiba 285-8668 (JP)**
• **OMICHI Koji**
**Sakura-shi, Chiba 285-8668 (JP)**
• **KIYOOKA Ryuichi**
**Sakura-shi, Chiba 285-8668 (JP)**
• **TANGE Mutsuko**
**Sakura-shi, Chiba 285-8668 (JP)**
• **UOTA Masafumi**
**Sakura-shi, Chiba 285-8668 (JP)**

(74) Representative: **Schön, Christoph**
**Dr. Schön, Neymeyr & Partner mbB**
**Bavariaring 26**
**80336 München (DE)**

(54) **NIOBATE PARTICLES, PRODUCTION METHOD OF NIOBATE PARTICLES, RESIN COMPOSITION AND MOLDED BODY**

(57)     An object of the present invention is to provide niobate particles having an excellent degree of crystal growth. The present invention relates to niobate particles including a crystal structure of niobate represented by $K_xNa_{(1-x)}Nb_yTa_{(1-y)}O_3$, where $0 \leq x \leq 1$, and $0 < y \leq 1$. The crystal structure has an average crystallite size of 80 nm or greater as determined from a peak at $2\theta = 23.0 \pm 1.0°$ of the niobate, the peak being a peak obtained in an X-ray diffraction measurement.

FIG. 1

EXAMPLE 1

EP 4 512 776 A1

**Description**

Technical Field

The present invention relates to niobate particles, to a method for producing niobate particles, to a resin composition, and to a molded article.
The present application claims priority to Japanese Patent Application No. 2022-070229, filed in Japan on April 21, 2022, the contents of which are incorporated herein by reference.

Background Art

Niobates are widely used, for example, in piezoelectric elements, fillers, catalysts, and water purification materials.
Patent Literature 1 describes, in Examples, a method for producing sodium potassium niobate particles. In the method, raw material powders of $Na_2CO_3$, $K_2CO_3$, and $Nb_2O_5$ are used, and a mixture of the raw material powders is sintered at 1100°C for 2 hours and subsequently ground.

Citation List

Patent Literature

PTL 1: Japanese Unexamined Patent Application Publication No. 2020-145408

Summary of Invention

Technical Problem

Controlling the crystal growth of niobate particles is a very important technique for enhancing the versatility of uses of the resulting niobate particles. $K_xNa_{(1-x)}NbO_3$ ($0 \leq x \leq 1$) has a perovskite structure and can be used, for example, as a piezoelectric element. Regarding piezoelectric materials, what is desired is that larger piezoelectric effects be produced with increasing crystallite sizes. Regarding niobate particles produced by a method of the related art for producing niobate particles, however, there is still room for further research for improving their crystal growth.
The present invention has been made to solve the problem, and an object of the present invention is to provide niobate particles having an excellent degree of crystal growth.

Solution to Problem

The present invention includes the following aspects.
(1) Niobate particles comprising a crystal structure of niobate represented by $K_xNa_{(1-x)}Nb_yTa_{(1-y)}O_3$, where $0 \leq x \leq 1$, and $0 < y \leq 1$, wherein
the crystal structure has an average crystallite size of 80 nm or greater as determined from a peak at $2\theta = 23.0 \pm 1.0°$ of the niobate, the peak being a peak obtained in an X-ray diffraction measurement.
(2) The niobate particles according to (1), wherein the crystal structure comprises a perovskite crystal structure.
(3) The niobate particles according to (1) or (2), wherein the niobate particles have a cubic shape.
(4) The niobate particles according to any one of (1) to (3), wherein the crystal structure has an average crystallite size of 50 nm or greater as determined from a peak at $2\theta = 32.0 \pm 1.2°$ of the niobate, the peak being a peak obtained in an X-ray diffraction measurement.
(5) The niobate particles according to any one of (1) to (4), wherein the niobate particles have a particle size $D_{50}$ of 0.1 to 100 $\mu$m as calculated by a laser diffraction light scattering method.
(6) The niobate particles according to any one of (1) to (5), wherein a ratio R between a peak intensity I (100) and a peak intensity I (110) is 1 or greater, where the peak intensity I (100) is an intensity of the peak at $2\theta = 23.0 \pm 1.0°$ of the niobate, and the peak is obtained in the X-ray diffraction measurement, and where the peak intensity I
(110) is an intensity of a peak at $2\theta = 32.0 \pm 1.2°$ of the niobate, and the peak is obtained in an X-ray diffraction measurement.

$$R = I(100)/I(110)$$

(7) The niobate particles according to any one of (1) to (6), wherein, in the niobate particles, a total content of niobium or of niobium and tantalum, in terms of a total content percentage calculated as $Nb_2O_5$ and $Ta_2O_5$, is 50 to 99 mass% as determined by an XRF analysis of the niobate particles, the total content percentage being based on a total mass of the niobate particles taken as 100 mass%.

(8) The niobate particles according to any one of (1) to (7), wherein, in the niobate particles, a content of potassium and/or sodium, in terms of a total content percentage calculated as $K_2O$ and $Na_2O$, is 0.5 to 40 mass% as determined by an XRF analysis of the niobate particles, the total content percentage being based on a total mass of the niobate particles taken as 100 mass%.

(9) The niobate particles according to any one of (1) to (8), further comprising molybdenum.

(10) The niobate particles according to (9), wherein, in the niobate particles, a content of the molybdenum, in terms of a content percentage calculated as $MoO_3$, is 0.01 to 20 mass% as determined by an XRF analysis of the niobate particles, the content percentage being based on a total mass of the niobate particles taken as 100 mass%.

(11) A method for producing niobate particles, which is a method for producing the niobate particles according to any one of (1) to (10), the method comprising firing a niobium compound or firing a niobium compound and a tantalum compound, in the presence of a potassium compound and/or a sodium compound.

(12) The method for producing niobate particles according to (11), wherein the sodium compound is sodium carbonate, and the potassium compound is potassium carbonate.

(13) The method for producing niobate particles according to (11) or (12), the method comprising firing the niobium compound or firing the niobium compound and the tantalum compound, in the presence of a molybdenum compound and of the potassium compound and/or the sodium compound.

(14) The method for producing niobate particles according to (13), wherein the molybdenum compound is at least one compound selected from the group consisting of molybdenum trioxide, potassium molybdate, and sodium molybdate.

(15) The method for producing niobate particles according to any one of (11) to (14), the method comprising a step of mixing the niobium compound, or the niobium compound and the tantalum compound, with the potassium compound and/or the sodium compound to form a mixture; and a step of firing the mixture, wherein

a molar ratio of potassium atoms and sodium atoms to niobium atoms and tantalum atoms in the mixture, which is a molar ratio denoted as (K+Na)/(Nb+Ta), is 1.1 or greater.

(16) A resin composition comprising the niobate particles according to any one of (1) to (10); and a resin.

(17) A molded article molded from the resin composition according to (16).

Advantageous Effects of Invention

The present invention can provide niobate particles having an excellent degree of crystal growth.

Furthermore, the present invention can provide a method for producing the niobate particles.

Furthermore, the present invention can provide a resin composition containing the niobate particles and provide a molded article of the resin composition.

Brief Description of Drawings

[Fig. 1] Fig. 1 is an SEM image of $K_xNa_{(1-x)}NbO_3$ particles of Example 1.
[Fig. 2] Fig. 2 is an SEM image of $K_xNa_{(1-x)}NbO_3$ particles of Example 2.
[Fig. 3] Fig. 3 is an SEM image of $K_xNa_{(1-x)}NbO_3$ particles of Example 3.
[Fig. 4] Fig. 4 is an SEM image of $K_xNa_{(1-x)}NbO_3$ particles of Example 4.
[Fig. 5] Fig. 5 is an SEM image of $K_xNa_{(1-x)}NbO_3$ particles of Example 5.
[Fig. 6] Fig. 6 is an SEM image of $NaNbO_3$ particles of Example 6.
[Fig. 7] Fig. 7 is an SEM image of $KNbO_3$ particles of Example 7.
[Fig. 8] Fig. 8 is an SEM image of $K_xNa_{(1-x)}Nb_yTa_{(1-y)}O_3$ particles of Example 8.
[Fig. 9] Fig. 9 is an SEM image of $K_xNa_{(1-x)}Nb_yTa_{(1-y)}O_3$ particles of Example 9.
[Fig. 10] Fig. 10 is an SEM image of $K_xNa_{(1-x)}Nb_yTa_{(1-y)}O_3$ particles of Example 10.
[Fig. 11] Fig. 11 is an SEM image of $K_xNa_{(1-x)}Nb_yTa_{(1-y)}O_3$ particles of Example 11.
[Fig. 12] Fig. 12 is an SEM image of $K_xNa_{(1-x)}Nb_yTa_{(1-y)}O_3$ particles of Example 12.
[Fig. 13] Fig. 13 is an SEM image of $K_xNa_{(1-x)}Nb_yTa_{(1-y)}O_3$ particles of Example 13.
[Fig. 14] Fig. 14 is an SEM image of $K_xNa_{(1-x)}NbO_3$ particles of Comparative Example 1.

[Fig. 15] Fig. 15 shows X-ray diffraction (XRD) patterns of powder samples of Examples 1 to 5.
[Fig. 16] Fig. 16 shows X-ray diffraction (XRD) patterns of powder samples of Examples 6 and 7.
[Fig. 17] Fig. 17 shows X-ray diffraction (XRD) patterns of powder samples of Examples 8 to 12.
[Fig. 18] Fig. 18 shows an X-ray diffraction (XRD) pattern of a powder sample of Example 13.
[Fig. 19] Fig. 19 shows an X-ray diffraction (XRD) pattern of a powder sample of Comparative Example 1.
[Fig. 20] Fig. 20 is a schematic diagram illustrating a configuration of a speaker used for evaluating a piezoelectric property in Examples.

Description of Embodiments

Embodiments of niobate particles and a method for producing the niobate particles and embodiments of a resin composition and a molded article, according to the present invention, will be described below.

<<Niobate Particles>>

According to an embodiment, niobate particles include a crystal structure of niobate represented by $K_xNa_{(1-x)}Nb_yTa_{(1-y)}O_3$, where $0 \leq x \leq 1$, and $0 < y \leq 1$. The crystal structure has an average crystallite size of 80 nm or greater as determined from a peak at $2\theta = 23.0 \pm 1.0°$ of the niobate, and the peak is obtained in an X-ray diffraction measurement.

The niobate particles of this embodiment contain niobate compound represented by $K_xNa_{(1-x)}Nb_yTa_{(1-y)}O_3$. In the formula $K_xNa_{(1-x)}Nb_yTa_{(1-y)}O_3$, $0 \leq x \leq 1$, and $0 < y \leq 1$.

When $0 < x < 1$, and $0 < y < 1$, $K_xNa_{(1-x)}Nb_yTa_{(1-y)}O_3$ represents sodium potassium niobate tantalate.

When $X = 0$, and $0 < y < 1$, $K_xNa_{(1-x)}Nb_yTa_{(1-y)}O_3$ represents sodium niobate tantalate ($NaNb_yTa_{(1-y)}O_3$).

When $X = 1$, and $0 < y < 1$, $K_xNa_{(1-x)}Nb_yTa_{(1-y)}O_3$ represents potassium niobate tantalate ($KNb_yTa_{(1-y)}O_3$).

When $0 < x < 1$, and $y = 1$, $K_xNa_{(1-x)}Nb_yTa_{(1-y)}O_3$ represents sodium potassium niobate ($K_xNa_{(1-x)}NbO_3$).

When $X = 0$, and $y = 1$, $K_xNa_{(1-x)}Nb_yTa_{(1-y)}O_3$ represents sodium niobate ($NaNbO_3$).

When $X = 1$, and $y = 1$, $K_xNa_{(1-x)}Nb_yTa_{(1-y)}O_3$ represents potassium niobate ($KNbO_3$).

Regarding piezoelectric materials, it is known that they can include a composition called a "morphotropic phase boundary (MPB) composition", which is associated with a boundary between different crystal systems (e.g., a monoclinic system and an orthorhombic system, or an orthorhombic system and a tetragonal system), and that including such a composition is preferable in terms of properties. The value x and the value y, mentioned above, can be adjusted such that a composition near the phase boundary can be obtained. In the $K_xNa_{(1-x)}Nb_yTa_{(1-y)}O_3$ it is preferable that $0.4 \leq x \leq 0.6$, and it is more preferable that $0.45 \leq x \leq 0.55$, for example. In the $K_xNa_{(1-x)}Nb_yTa_{(1-y)}O_3$ it is preferable that $0.5 \leq y \leq 1$, for example.

Note that instead of the MPB composition, a composition that is outside the MPB composition range may be included to improve properties other than a piezoelectric property, such as durability. Accordingly, the composition of the niobate particles of this embodiment is not limited to the preferred ranges, and compositions over the entire ranges of $0 \leq x \leq 1$ and $0 < y \leq 1$ are effective.

Furthermore, an element having a lower valence than Nb, such as Mn, Cr, Co, Ni, or Zn, may be appropriately included in an amount of several (1 to 3) mol% or less based on the amount of the Nb so that leakage currents can be suppressed to maintain insulating properties. Furthermore, incidental impurities, such as Fe, derived from raw materials may be present.

In the present specification, x and y are any of the values specified above, and in any of the cases, the particles including $K_xNa_{(1-x)}Nb_yTa_{(1-y)}O_3$ may simply be referred to as "niobate particles". Furthermore, the description of the ranges of the values of x and y may be omitted in some cases.

Regarding the niobate present in the niobate particles of this embodiment, its type, composition, and crystal structure can be determined from an XRD spectrum pattern obtained in an XRD analysis.

The average crystallite size of the crystal structure present in the niobate particles of this embodiment can be determined by the measurement method described below.

[Measurement of Crystallite Size]

For the measurement, an X-ray diffractometer (e.g., SmartLab, manufactured by Rigaku Corporation) is used, a high-intensity high-resolution crystal analyzer (CALSA) is used as a detector, and analysis software is used. The measurement mode is the $2\theta$-$\theta$ mode. The average crystallite size is calculated from the full width at half maximum of the peak of interest (peak having a peak top within the range of $2\theta$ of interest) using the Scherrer equation. The measurement conditions are as follows: a scanning speed of 0.05°/min, a scanning range of 20 to 70°, a step of 0.002°, and an instrument standard broadening of 0.028° (Si).

The crystal structure present in the niobate particles of this embodiment has an average crystallite size of 80 nm or greater as determined from a peak at $2\theta = 23.0 \pm 1.0°$. The average crystallite size is preferably 90 nm or greater and more preferably 100 nm or greater.

When the average crystallite size of the niobate particles is greater than or equal to the lower limit, a resulting piezoelectric property is excellent.

The average crystallite size of the crystal structure present in the niobate particles of this embodiment as determined from a peak at $2\theta = 23.0 \pm 1.0°$ may have an upper limit, which is not particularly limited and may be 1000 nm or less, 800 nm or less, or 500 nm or less.

Regarding the average crystallite size of the crystal structure present in the niobate particles of this embodiment as determined from a peak at $2\theta = 23.0 \pm 1.0°$, an example of a range of the value may be 80 nm or greater and 1000 nm or less, 90 nm or greater and 800 nm or less, or 100 nm or greater and 500 nm or less.

The crystal system of $K_xNa_{(1-x)}Nb_yTa_{(1-y)}O_3$ varies depending on the composition and may be monoclinic, orthorhombic, or tetragonal. Thus, the identification of the planes depends on the crystal system. In the present specification, the notation of the plane index is based on an assumption that the crystal structure is cubic, unless otherwise specified.

Regarding the peak of interest obtained in the measurement of the crystallite size, the peak at $2\theta = 23.0 \pm 1.0°$ is a peak at a position corresponding to the (100) plane of a cubic system, provided that the peak is identified without taking peak splitting into account and assuming that the crystal system is cubic. If there is peak splitting, the peak with the highest intensity is used to determine the crystallite size.

The crystal structure present in the niobate particles of this embodiment may have an average crystallite size determined from a peak at $2\theta = 32.0 \pm 1.2°$, and the average crystallite size is preferably 50 nm or greater, more preferably 80 nm or greater, and even more preferably 100 nm or greater.

When this average crystallite size of the niobate particles is greater than or equal to the lower limit, a resulting piezoelectric property is enhanced.

The average crystallite size of the crystal structure present in the niobate particles of this embodiment as determined from a peak at $2\theta = 32.0 \pm 1.2°$ may have an upper limit, which is not particularly limited and may be 1000 nm or less, 800 nm or less, or 700 nm or less.

Regarding the average crystallite size of the crystal structure present in the niobate particles of this embodiment as determined from a peak at $2\theta = 32.0 \pm 1.2°$, an example of a range of the value may be 50 nm or greater and 1000 nm or less, 80 nm or greater and 800 nm or less, or 100 nm or greater and 700 nm or less.

Regarding the peak of interest obtained in the measurement of the crystallite size, the peak at $2\theta = 32.0 \pm 1.2°$ is a peak at a position corresponding to the (110) plane of a cubic system, provided that the peak is identified without taking peak splitting into account and assuming that the crystal system is cubic. If there is peak splitting, the peak with the highest intensity is used to determine the crystallite size.

The crystal structure present in the niobate particles of this embodiment may have an average crystallite size determined from a peak at $2\theta = 57.0 \pm 1.0°$, and the average crystallite size is preferably 15 nm or greater, more preferably 20 nm or greater, and even more preferably 30 nm or greater.

When this average crystallite size of the niobate particles is greater than or equal to the lower limit, a resulting piezoelectric property is enhanced.

The average crystallite size of the crystal structure present in the niobate particles of this embodiment as determined from a peak at $2\theta = 57.0 \pm 1.0°$ may have an upper limit, which is not particularly limited and may be 500 nm or less, 400 nm or less, or 300 nm or less.

Regarding the average crystallite size of the crystal structure present in the niobate particles of this embodiment as determined from a peak at $2\theta = 57.0 \pm 1.0°$, an example of a range of the value may be 15 nm or greater and 500 nm or less, 20 nm or greater and 400 nm or less, or 30 nm or greater and 300 nm or less.

Regarding the peak of interest obtained in the measurement of the crystallite size, the peak at $2\theta = 57.0 \pm 1.0°$ is a peak at a position corresponding to the (211) plane of a cubic system, provided that the peak is identified without taking peak splitting into account and assuming that the crystal system is cubic. If there is peak splitting in the peak of interest, the peak with the highest intensity is used to determine the crystallite size.

A production method according to an embodiment, described later, has excellent control of the crystal growth of the niobate particles that are produced and, therefore, can readily produce niobate particles having an improved average crystallite size.

The average crystallite size can be controlled with an amount and a type of a fluxing agent that is used and firing conditions that are employed, in the production method described later.

The crystal structure of the niobate particles of this embodiment may include a perovskite crystal structure.

The niobate particles of this embodiment may have a cubic shape.

In the present specification, the term "cubic shape" may refer to a shape derived from the perovskite structure; the shape is preferably a shape of a hexahedron that is substantially a cube, and each of the faces that constitute the hexahedron may be a flat face, a curved face, or an uneven face.

Regarding the above-mentioned peaks obtained in an X-ray diffraction measurement, a ratio R between a peak intensity I (100) and a peak intensity I (110) may be determined, where the peak intensity I (100) is an intensity of the peak having a peak top at $2\theta = 23.0 \pm 1.0°$, and the peak intensity I (110) is an intensity of the peak having a peak top at $2\theta = 32.0 \pm 1.2°$.

$$R = I(100)/I(110)$$

The peak intensities to be employed are each the value at the peak top of the peak of interest.

Regarding the niobate particles of this embodiment, the value of R is preferably greater than or equal to 1, more preferably greater than or equal to 1.1, even more preferably greater than or equal to 2, and particularly preferably greater than or equal to 3.

Presumably, the fact that the measured value of the diffraction at I (100), which corresponds to the peak top at $2\theta = 23.0 \pm 1.0°$, is high, that is, the value of R is greater than or equal to 1, indicates that in the sample that is of interest for the measurement, particles are disposed such that the faces of hexahedrons that correspond to the (100) plane are oriented in a uniform direction. Presumably, this is more likely to occur as uniformity in shape of the particles increases.

That is, when the value of R is greater than or equal to 1, the niobate particles of this embodiment have high uniformity in shape of the particles and are, therefore, of high quality.

When the value of R is greater than or equal to 1, a resin composition including the niobate particles of this embodiment, which will be described later, has excellent filler properties.

The production method of the embodiment described later enables the production of niobate particles having a perovskite crystal structure and a cubic shape.

As a firing temperature increases, it is more likely that niobate particles having a large average crystallite size and also having a large particle size can be obtained.

When the niobate particles have a cubic shape, the particle size is preferably greater than or equal to 0.1 $\mu$m, more preferably greater than or equal to 0.5 $\mu$m, and even more preferably greater than or equal to 1 $\mu$m.

When the niobate particles have a cubic shape, an upper limit of the particle size is not particularly limited and may be, for example, 100 $\mu$m or less, 80 $\mu$m or less, or 50 $\mu$m or less.

When the niobate particles have a cubic shape, an example of a range of the value of the upper limit of the particle size may be 0.1 to 100 $\mu$m, 0.5 to 80 $\mu$m, or 1 to 50 $\mu$m.

In the present specification, the "particle size" of niobate particles having a cubic shape is a length of a side of the hexahedron as determined from a particle image of a primary particle of the niobate particles in a two-dimensional image acquired with a scanning electron microscope (SEM).

The value of the particle size of the niobate particles having a cubic shape is an average of the values obtained from 50 or more niobate particles randomly selected from particles having a euhedral shape, which are particles of interest for the measurement.

In the instance where niobate particles having a cubic shape are present, it is preferable that 50% or more particles have a cubic shape, it is more preferable that 80% or more particles have a cubic shape, and it is even more preferable that 90% or more particles have a cubic shape, where the percentages are mass-based or number-based percentages.

The niobate particles of this embodiment may have a particle size $D_{50}$ of 0.1 to 100 $\mu$m, 0.5 to 80 $\mu$m, or 1 to 50 $\mu$m, as calculated by a laser diffraction light scattering method.

The niobate particles of this embodiment may have a $D_{10}$ of 0.05 to 70 $\mu$m, 0.1 to 50 $\mu$m, or 0.5 to 20 $\mu$m, as calculated by a laser diffraction light scattering method.

The niobate particles of this embodiment may have a particle size $D_{90}$ of 0.5 to 150 $\mu$m, 1 to 100 $\mu$m, or 3 to 70 $\mu$m, as calculated by a laser diffraction light scattering method.

The particle size $D_{50}$ of a sample of the niobate particles as calculated by a laser diffraction light scattering method can be determined as a particle size corresponding to a cumulative volume percentage of 50% in a particle size distribution measured in a dry state with a laser diffraction particle size distribution analyzer. The $D_{10}$ can be determined as a particle size corresponding to a point at which the cumulative volume percent distribution curve intersects a horizontal axis located 10% away from the small particle side, and the $D_{90}$ can be determined as a particle size corresponding to a point at which the cumulative volume percent distribution curve intersects a horizontal axis located 90% away from the small particle side, where the $D_{10}$ and $D_{90}$ are particle sizes of the sample of the niobate particles as calculated by a laser diffraction light scattering method.

The niobate particles of this embodiment may have a specific surface area of 0.02 to 20 $m^2$/g, 0.04 to 10 $m^2$/g, or 0.05 to 3 $m^2$/g, as determined by a BET method.

The specific surface area is determined as follows. A measurement is performed with a specific surface area analyzer (e.g., Belsorp mini, manufactured by MicrotracBEL), and the specific surface area ($m^2$/g) is calculated as a surface area per gram of the sample, which is measured from an amount of adsorption of nitrogen gas in accordance with the BET (Brunauer-Emmett-Teller) method.

The niobate particles of this embodiment contain $K_xNa_{(1-x)}Nb_yTa_{(1-y)}O_3$, where $0 \leq x \leq 1$, $0 < y \leq 1$.

In the niobate particles of this embodiment, it is preferable that $K_xNa_{(1-x)}Nb_yTa_{(1-y)}O_3$ be present preferably in an amount of 65 mass% or greater, preferably in an amount of 65 to 99.999 mass%, more preferably in an amount of 70 to 99.97 mass%, and even more preferably 75 to 99.95 mass%, based on the 100 mass% of the niobate particles.

The niobate particles of this embodiment contain niobium and may further contain tantalum.

In the niobate particles, a total content of niobium or of niobium and tantalum, in terms of a total content percentage calculated as $Nb_2O_5$ and $Ta_2O_5$, may be 50 mass% or greater, 50 to 99 mass%, 60 to 98 mass%, or 70 to 95 mass%, as determined by an XRF analysis of the niobate particles, the total content percentage being based on the total mass of the niobate particles taken as 100 mass%.

The "total content percentage calculated as $Nb_2O_5$ and $Ta_2O_5$" is a value determined from the sum of an amount of $Nb_2O_5$ and an amount of $Ta_2O_5$. The amount of $Nb_2O_5$ is calculated from a content of niobium determined by an XRF analysis, with the calculation being performed using a $Nb_2O_5$ calculation standard curve. The amount of $Ta_2O_5$ is calculated from a content of tantalum determined by an XRF analysis, with the calculation being performed using a $Ta_2O_5$ calculation standard curve. Note that when the niobate particles have a composition of $K_xNa_{(1-x)}Nb_yTa_{(1-y)}O_3$ in which $y = 1$, the content of tantalum may be 0.

The niobate particles of this embodiment contain potassium and/or sodium.

In the niobate particles, a content of potassium and/or sodium, in terms of a total content percentage calculated as $K_2O$ and $Na_2O$, may be 0.5 mass% or greater, 0.5 to 40 mass%, 1 to 30 mass%, or 3 to 25 mass%, as determined by an XRF analysis of the niobate particles, the total content percentage being based on the total mass of the niobate particles taken as 100 mass%.

The "total content percentage calculated as $K_2O$ and $Na_2O$" is a value determined from the sum of an amount of $K_2O$ and an amount of $Na_2O$. The amount of $K_2O$ is calculated from a content of potassium determined by an XRF analysis, with the calculation being performed using a $K_2O$ calculation standard curve. The amount of $Na_2O$ is calculated from a content of sodium determined by an XRF analysis, with the calculation being performed using a $Na_2O$ calculation standard curve. Note that when the niobate particles have a composition of $K_xNa_{(1-x)}Nb_yTa_{(1-y)}O_3$ in which $x = 0$ or 1, the content of potassium or the content of sodium may be 0.

The niobate particles of this embodiment may further contain molybdenum.

The niobate particles of this embodiment may contain molybdenum derived from a molybdenum compound that may be used in the production method described later. Furthermore, in the instance where a molybdenum compound is used in the production method described later, highly efficient crystal growth can be achieved in the niobate particles of this embodiment.

Regarding the molybdenum that is present in the niobate particles of this embodiment, a state of existence and an amount of the molybdenum are not particularly limited. Examples of the molybdenum that may be present in the niobate particles include molybdenum metal, molybdenum oxide, and partially reduced molybdenum compounds. It can be assumed that the molybdenum is present as $MoO_3$ in the niobate particles. In addition to $MoO_3$, one or more other types of molybdenum, such as $MoO_2$ and $MoO$, may be present in the niobate particles.

The form in which the molybdenum is present is not particularly limited, and any of the following forms are possible: a form in which molybdenum adheres to a surface of the niobate particles; a form in which molybdenum replaces a portion of the crystal structure of the niobate particles; an amorphous form; and a combination of any of these forms.

In the instance where the niobate particles of this embodiment contain molybdenum, a content of the molybdenum, in terms of a content percentage calculated as $MoO_3$, may be 0.01 mass% or greater, 0.01 to 20 mass%, 0.05 to 15 mass%, or 0.06 to 10 mass%, as determined by an XRF analysis of the niobate particles, the content percentage being based on the total mass of the niobate particles taken as 100 mass%.

The "content percentage calculated as $MoO_3$" is a value determined from an amount of $MoO_3$. The amount of $MoO_3$ is calculated from a content of molybdenum determined by an XRF analysis, with the calculation being performed using a $MoO_3$ calculation standard curve.

Regarding the content of molybdenum, the total content of niobium and tantalum, and the total content of potassium and sodium, the values of the contents may be selected in a desired combination.

As an example, the niobate particles of this embodiment may be niobate particles in which the content percentage of molybdenum calculated as $MoO_3$ is 0 to 20 mass%, the total content percentage of niobium and tantalum calculated as $Nb_2O_5$ and $Ta_2O_5$ is 50 to 99 mass%, and the total content percentage of potassium and sodium calculated as $K_2O$ and $Na_2O$ is 0.5 to 40 mass%, as determined by an XRF analysis of the niobate particles, the content percentages being based on the total mass of the niobate particles taken as 100 mass%.

As another example, the niobate particles of this embodiment may be niobate particles in which the content percentage of molybdenum calculated as $MoO_3$ is 0.01 to 20 mass%, the total content percentage of niobium and tantalum calculated as $Nb_2O_5$ and $Ta_2O_5$ is 50 to 99 mass%, and the total content percentage of potassium and sodium calculated as $K_2O$ and $Na_2O$ is 0.5 to 40 mass%, as determined by an XRF analysis of the niobate particles, the content percentages being based on the total mass of the niobate particles taken as 100 mass%.

As another example, the niobate particles of this embodiment may be niobate particles in which the content percentage of molybdenum calculated as $MoO_3$ is 0.05 to 15 mass%, the total content percentage of niobium and tantalum calculated as $Nb_2O_5$ and $Ta_2O_5$ is 60 to 98 mass%, and the total content percentage of potassium and sodium calculated as $K_2O$ and $Na_2O$ is 1 to 30 mass%, as determined by an XRF analysis of the niobate particles, the content percentages being based on the total mass of the niobate particles taken as 100 mass%.

As another example, the niobate particles of this embodiment may be niobate particles in which the content percentage of molybdenum calculated as $MoO_3$ is 0.06 to 10 mass%, the total content percentage of niobium and tantalum calculated as $Nb_2O_5$ and $Ta_2O_5$ is 70 to 95 mass%, and the total content percentage of potassium and sodium calculated as $K_2O$ and $Na_2O$ is 3 to 25 mass%, as determined by an XRF analysis of the niobate particles, the content percentages being based on the total mass of the niobate particles taken as 100 mass%.

The niobate particles of this embodiment may be provided as aggregates of niobate particles. The crystallite size, the particle size distribution, the specific surface area, the values of x and y, and the values of the content of molybdenum, the content of niobium, the content of tantalum, the content of potassium, and the content of sodium, mentioned above, may be values determined by using the aggregates as a sample.

The niobate particles of this embodiment can be produced, for example, according to <<Method for Producing Niobate Particles>>, described below.

Note that the niobate particles of the present invention are not limited to those produced by the method of the embodiment below for producing niobate particles.

The niobate particles of this embodiment can be used in piezoelectric elements, catalysts, water purification materials, and the like.

<<Method for Producing Niobate Particles>>

According to an embodiment, the method for producing niobate particles includes firing a niobium compound or firing a niobium compound and a tantalum compound, in the presence of a potassium compound and/or a sodium compound.

The method of this embodiment for producing niobate particles enables the production of the niobate particles of the above embodiment of the present invention.

In the method of this embodiment for producing niobate particles, the firing of a niobium compound or of a niobium compound and a tantalum compound is performed in the presence of a potassium compound and/or a sodium compound, and as a result, the niobate particles that are produced have an excellent degree of crystal growth.

In the method of this embodiment for producing niobate particles, the firing of a niobium compound or of a niobium compound and a tantalum compound may be performed in the presence of potassium carbonate and/or sodium carbonate, and as a result, the niobate particles that are produced have an enhanced degree of crystal growth.

Preferably, the method for producing niobate particles may include a step (mixing step) in which a niobium compound, or a niobium compound and a tantalum compound, are mixed with a potassium compound and/or a sodium compound to form a mixture and include a step (firing step) in which the mixture is fired.

In the method of this embodiment for producing niobate particles, it is preferable that a molybdenum compound be additionally used. The use of a molybdenum compound can further promote the crystal growth in the niobate particles and, therefore, can produce the niobate particles with high efficiency.

As an example, a method for producing such niobate particles may be a method that includes firing a niobium compound or firing a niobium compound and a tantalum compound, in the presence of a molybdenum compound, a potassium compound, and/or a sodium compound.

Preferably, the method for producing niobate particles may include a step (mixing step) in which a niobium compound, or a niobium compound and a tantalum compound, are mixed with a molybdenum compound, a potassium compound, and/or a sodium compound to form a mixture and include a step (firing step) in which the mixture is fired.

The molybdenum compound and the potassium compound may be at least partially replaced with a compound containing molybdenum and potassium, such as potassium molybdate. Likewise, the molybdenum compound and the sodium compound may be at least partially replaced with a compound containing molybdenum and sodium, such as sodium molybdate.

Accordingly, mixing a compound containing molybdenum and containing potassium and/or sodium is also regarded as mixing a molybdenum compound and mixing a potassium compound and/or a sodium compound.

[Mixing Step]

The mixing step is a step of mixing a niobium compound, or a niobium compound and a tantalum compound, with a potassium compound and/or a sodium compound, and, if desired, a molybdenum compound, to form a mixture.

In the instance where the niobate particles that are produced contain sodium potassium niobate tantalate, it is possible to include a step (mixing step) in which a niobium compound, a tantalum compound, a potassium compound, a sodium compound, and, if desired, a molybdenum compound, are mixed together to form a mixture.

In the instance where the niobate particles that are produced contain sodium potassium niobate, it is possible to include a step (mixing step) in which a niobium compound, a potassium compound, a sodium compound, and, if desired, a molybdenum compound, are mixed together to form a mixture.

In the instance where the niobate particles that are produced contain potassium niobate, it is possible to include a step (mixing step) in which a niobium compound, a potassium compound, and, if desired, a molybdenum compound, are mixed together to form a mixture.

In the instance where the niobate particles that are produced contain sodium niobate, it is possible to include a step (mixing step) in which a niobium compound, a sodium compound, and, if desired, a molybdenum compound, are mixed together to form a mixture.

The ingredients in the mixture will be described below.

(Niobium Compound)

The niobium compound may be any compound that can form niobate when the compound is fired with a raw material compound, and examples of the niobium compound include niobium oxide, niobium hydroxide, niobium sulfide, niobium nitride, niobium halides, such as niobium fluoride, niobium chloride, niobium bromide, and niobium iodide, and niobium alkoxides; niobium hydroxide and niobium oxide are preferable, and niobium oxide is more preferable. Examples of niobium oxide include niobium pentoxide ($Nb_2O_5$), niobium dioxide ($NbO_2$), and niobium monoxide (NbO). Any other niobium oxide with a different valence may be used in addition to or in place of the niobium oxides with the mentioned oxidation numbers.

The physical properties of the niobium compounds that serve as precursors are not particularly limited, and examples of the physical properties include the shape, the particle size, and the specific surface area.

The shape resulting from the firing is a shape that substantially does not reflect the shape of the niobium compound used as a raw material. Accordingly, a niobium compound having any of a variety of shapes may be suitably used. Examples of the shapes include spherical shapes, amorphous shapes, shapes of a structure having an aspect (e.g., a wire, a fiber, a ribbon, or a tube), and sheet shapes.

(Tantalum Compound)

The tantalum compound may be any compound that can form niobate when the compound is fired with a raw material compound, and examples of the tantalum compound include tantalum oxide, tantalum hydroxide, tantalum sulfide, tantalum nitride, tantalum halides, such as tantalum fluoride, tantalum chloride, tantalum bromide, and tantalum iodide, and tantalum alkoxides; tantalum hydroxide and tantalum oxide are preferable, and tantalum oxide is more preferable.

Examples of tantalum oxide include tantalum pentoxide ($Ta_2O_5$), tantalum dioxide ($TaO_2$), and tantalum monoxide (TaO). Any other tantalum oxide with a different valence may be used in addition to or in place of the tantalum oxides with the mentioned oxidation numbers.

The physical properties of the tantalum compounds that serve as precursors are not particularly limited, and examples of the physical properties include the shape, the particle size, and the specific surface area.

The shape resulting from the firing is a shape that substantially does not reflect the shape of the tantalum compound used as a raw material. Accordingly, a tantalum compound having any of a variety of shapes may be suitably used. Examples of the shapes include spherical shapes, amorphous shapes, shapes of a structure having an aspect (e.g., a wire, a fiber, a ribbon, or a tube), and sheet shapes.

(Molybdenum Compound)

Examples of the molybdenum compound include molybdenum oxide, molybdic acids, molybdenum sulfide, and molybdate compounds; molybdenum oxide or a molybdate compound is preferable.

Examples of the molybdenum oxide include molybdenum dioxide ($MoO_2$) and molybdenum trioxide ($MoO_3$), and molybdenum trioxide is preferable.

The molybdate compound is preferably an alkali metal salt of a molybdenum oxoanion, more preferably lithium molybdate, potassium molybdate, or sodium molybdate, and even more preferably potassium molybdate or sodium molybdate.

In the method of this embodiment for producing niobate particles, the molybdenum compound may be a hydrate.

The molybdenum compound is preferably at least one compound selected from the group consisting of molybdenum trioxide, lithium molybdate, potassium molybdate, and sodium molybdate and more preferably at least one compound selected from the group consisting of molybdenum trioxide, potassium molybdate, and sodium molybdate.

Compounds containing molybdenum and potassium, which are suitable as a fluxing agent, can be produced, for example, in the process of firing by using, as raw materials, a molybdenum compound and a potassium compound, which are less expensive and more readily available. In this specification, the instance in which a molybdenum compound and a potassium compound are used as fluxing agents and the instance in which a compound containing molybdenum and potassium is used as a fluxing agent are both regarded as the instance in which a molybdenum compound and a potassium compound are used as fluxing agents, that is, the instance referred to as the "presence of a molybdenum compound and a potassium compound".

Compounds containing molybdenum and sodium, which are suitable as a fluxing agent, can be produced, for example, in the process of firing by using, as raw materials, a molybdenum compound and a sodium compound, which are less expensive and more readily available. In this specification, the instance in which a molybdenum compound and a sodium compound are used as fluxing agents and the instance in which a compound containing molybdenum and sodium is used as a fluxing agent are both regarded as the instance in which a molybdenum compound and a sodium compound are used as fluxing agents, that is, the instance referred to as the "presence of a molybdenum compound and a sodium compound".

The molybdenum compounds mentioned above may be used alone or in a combination of two or more.

The potassium molybdate ($K_2Mo_nO_{3n+1}$, n=1 to 3) can also have functions of a potassium compound, which will be described below, because the potassium molybdate contains potassium.

The sodium molybdate ($Na_2Mo_nO_{3n+1}$, n=1 to 3) can also have functions of a sodium compound, which will be described below, because the sodium molybdate contains sodium.

(Potassium Compound)

Examples of the potassium compound include, but are not limited to, potassium chloride, potassium chlorite, potassium chlorate, potassium sulfate, potassium hydrogen sulfate, potassium sulfite, potassium bisulfite, potassium nitrate, potassium carbonate, potassium hydrogen carbonate, potassium acetate, potassium oxide, potassium bromide, potassium bromate, potassium hydroxide, potassium silicate, potassium phosphate, potassium hydrogen phosphate, potassium sulfide, potassium hydrogen sulfide, potassium molybdate, and potassium tungstate. These potassium compounds include isomers, as in the instance of the molybdenum compounds. Among these, potassium carbonate, potassium hydrogen carbonate, potassium oxide, potassium hydroxide, potassium chloride, potassium sulfate, and potassium molybdate are preferable; potassium carbonate, potassium hydrogen carbonate, potassium chloride, potassium sulfate, and potassium molybdate are more preferable, and potassium carbonate and/or potassium molybdate are more preferable.

The potassium compounds mentioned above may be used alone or in a combination of two or more.

As with the instance described above, the potassium molybdate can also have functions of a molybdenum compound because the potassium molybdate contains molybdenum.

(Sodium Compound)

Examples of the sodium compound include, but are not limited to, sodium carbonate, sodium molybdate, sodium oxide, sodium sulfate, sodium hydroxide, sodium nitrate, sodium chloride, and metallic sodium. Among these, sodium carbonate, sodium molybdate, sodium oxide, and sodium sulfate are preferable in terms of industrial availability and ease of handling; sodium carbonate and/or sodium molybdate are more preferable.

The sodium compounds mentioned above may be used alone or in a combination of two or more.

As with the instance described above, the sodium molybdate can also have functions of a molybdenum compound because the sodium molybdate contains molybdenum.

Thus, some of the compounds are redundantly referred to as a molybdenum compound under a different classification. It is preferable, for example, that the molybdenum compound be at least one compound selected from the group consisting of molybdenum trioxide, potassium molybdate, and sodium molybdate, that the sodium compound be sodium carbonate or sodium molybdate, and that the potassium compound be potassium carbonate or potassium molybdate.

A preferred example is a method for producing sodium potassium niobate particles including firing a niobium compound in the presence of a molybdenum compound, a potassium compound, and a sodium compound.

A preferred example is a method for producing sodium niobate particles including firing a niobium compound in the presence of a molybdenum compound and a sodium compound.

A preferred example is a method for producing potassium niobate particles including firing a niobium compound in the presence of a molybdenum compound and a potassium compound.

A preferred example is a method for producing sodium potassium niobate tantalate particles including firing a niobium compound and a tantalum compound in the presence of a molybdenum compound, a potassium compound, and a sodium compound.

A preferred example is a method for producing sodium potassium niobate tantalate particles including firing a niobium compound and a tantalum compound in the presence of a potassium compound and a sodium compound.

In the method of this embodiment for producing niobate particles, the potassium compound, the sodium compound, and the molybdenum compound are used as fluxing agents.

Probably, in instances where a potassium compound and/or a sodium compound are used as fluxing agents, the firing causes a portion of the potassium compound and/or the sodium compound to form oxides ($Na_2O$ and/or $K_2O$), which serve as flux to enable the progression of the crystal growth of the niobate.

Furthermore, probably, in instances where the niobium compound is fired in the presence of potassium carbonate and/or sodium carbonate, a portion of the potassium carbonate and/or the sodium carbonate forms oxides ($Na_2O$ and/or $K_2O$) and/or $CO_2$, and these oxides and/or $CO_2$ serve as flux to enable the progression of the crystal growth of the niobate particles.

Presumably, the firing causes reactions, which form niobate particles ($K_xNa_{(1-x)}Nb_yTa_{(1-y)}O_3$) while forming oxides ($Na_2O$ and/or $K_2O$) and/or $CO_2$ that serve as flux. Presumably, because of the oxides ($Na_2O$ and/or $K_2O$) and/or $CO_2$ that serve as flux, the formation of niobate particles ($K_xNa_{(1-x)}Nb_yTa_{(1-y)}O_3$) having a large crystallite size is promoted.

Presumably, in instances where a molybdenum compound is used as a fluxing agent, the firing causes a reaction of the molybdenum compound and of a sodium compound or a potassium compound with a niobium compound, or with a niobium compound and a tantalum compound, at a high temperature (this is also true for the instances in which a compound containing molybdenum and sodium is used, or a compound containing molybdenum and potassium is used), thereby forming niobate particles ($K_xNa_{(1-x)}Nb_yTa_{(1-y)}O_3$) while forming a molybdate compound (e.g., $K_aMo_bO_c$, $Na_{a-}Mo_bO_c$, or $K_aNa_{a'}Mo_bO_c$) that serves as flux. Presumably, a portion of the molybdenum compound is incorporated into the niobate particles during the formation (crystal growth) of the niobate particles. Regarding more details of the mechanism by which the molybdenum compound that is included into the niobate particles is produced, the molybdenum compound, such as a molybdenum oxide, is presumably formed in the process of the crystal growth of the niobate particles during firing via the formation and decomposition of Mo-O-Nb and Mo-O-Ta in the system or via a molybdate compound that serves as a fluxing agent. Furthermore, in view of the mechanism, it can also be presumed that molybdenum oxide exists on a surface of the niobate particles via the bonds in Mo-O-Nb and Mo-O-Ta. The presence of a molybdenum compound (e.g., molybdenum oxide) in the niobate particles leads to improvement in the physical properties of the niobate particles, for example, improvement in catalytic properties of the niobate particles.

The molybdate compound serving as flux does not vaporize even in a firing temperature range and, after being fired, can be easily collected by washing. Accordingly, the amount of the molybdenum compound that is released to the outside of the firing furnace is reduced, and the cost of production can be significantly reduced.

In the method of this embodiment for producing niobate particles, a total amount of use of the raw materials that are believed to serve as fluxing agents, namely, the molybdenum compound, the potassium compound, and the sodium compound (hereinafter also referred to as "fluxing agents") and amounts of use of the niobium compound and the tantalum compound are not particularly limited. Preferably, 10 parts by mass or greater of the fluxing agents may be mixed with 100 parts by mass, in terms of a total amount of use, of the niobium compound and the tantalum compound that are raw materials, to form a mixture, and the mixture may be fired. More preferably, 20 to 5000 parts by mass of the fluxing agents may be mixed with 100 parts by mass, in terms of a total amount of use, of the niobium compound and the tantalum compound to form a mixture, and the mixture may be fired. Even more preferably, 100 to 1000 parts by mass of the fluxing agents may be mixed with 100 parts by mass, in terms of a total amount of use, of the niobium compound and the tantalum compound to form a mixture, and the mixture may be fired.

From the standpoint of efficient crystal growth, it is preferable that the amount of use of the fluxing agents, based on the amount of use of the niobium compound that is a raw material, be greater than or equal to the lower limit mentioned above. By increasing the amount of use of the fluxing agents based on the amount of use of the niobium compound that is a raw material, the crystallite size of the niobate particles that are produced can be easily controlled, and, consequently, niobate particles having an improved crystallite size can be readily obtained. On the other hand, from the standpoint of reducing the fluxing agents that are used and improving production efficiency, it is preferable that the amount be less than or equal to the upper limit mentioned above. When the amount of the fluxing agents is large, large single crystals may be produced, which may result in a decrease in productivity. Accordingly, the amount of the fluxing agents may be appropriately selected such that the niobate particles that are produced can have a desired particle size.

In the method of this embodiment for producing niobate particles, it is preferable, from a similar standpoint, that a molar ratio of potassium atoms and sodium atoms to niobium atoms and tantalum atoms in the mixture, which is a molar ratio denoted as (K+Na)/(Nb+Ta), be greater than or equal to 1.1. The molar ratio is more preferably 1.5 to 10, even more preferably 2.0 to 5, and particularly preferably 2.0 to 2.7.

When the molar ratio (K+Na)/(Nb+Ta) is within any of the mentioned ranges, niobate particles having an improved crystallite size can be readily obtained.

In the niobate particles ($K_xNa_{(1-x)}Nb_yTa_{(1-y)}O_3$) having a perovskite structure that are produced, the ratio (K+Na)/Nb+Ta is typically approximately (K+Na)/(Nb+Ta) =1 (a value within a range in which the perovskite structure is present). Presumably, an excess of (K+Na) in the mixture serves as so-called self-flux and contributes to favorable crystal growth of the niobate.

In the method of this embodiment for producing niobate particles, a molar ratio of potassium atoms and/or sodium atoms to molybdenum atoms in the mixture, which is a molar ratio denoted as (K+Na)/Mo, is preferably 1 to 4 and more preferably 1.5 to 4. In particular, when the (K+Na)/Mo is 2 to 4, a single composition of $K_xNa_{(1-x)}Nb_yO_z$ can be readily formed in the niobate particles that are produced.

In the method of this embodiment for producing niobate particles, a ratio of K/Na in the niobate particles that are produced can be varied in accordance with a compounding ratio of K/Na in the raw materials. The molar ratio of potassium atoms and/or sodium atoms to molybdenum atoms in the mixture may be appropriately selected in accordance with desired values of X and 1-X, which are values in the $K_xNa_{(1-x)}Nb_yTa_{(1-y)}O_3$, for the niobate particles that are produced. When 0 < X < 1, a molar ratio of potassium atoms to sodium atoms in the mixture, which is a molar ratio denoted as K/Na, may be, for example, 0.01 to 10 or 0.1 to 5.

In the instance where the compounds are used within any of the above-mentioned ranges, the amount of the molybdenum compound that is to be present in the resulting niobate particles becomes more appropriate, and niobate particles having a controlled crystal shape can be readily obtained.

[Firing Step]

The firing step is a step of firing the mixture. The niobate particles of the above embodiment can be obtained by firing the mixture. As described above, this production method is referred to as a "flux method".

The flux method is classified as a solution method. More specifically, the flux method is a method for growing crystals that utilizes an instance in which a crystal-flux binary phase diagram is of a eutectic type. The mechanism of the flux method is speculated to be as follows. Specifically, as a mixture of a solute and flux is heated, the solute and the flux form a liquid phase. In this process, since the flux is a fusing agent, that is, the solute-flux binary phase diagram is of a eutectic type, the solute melts at a temperature lower than its melting point to form a liquid phase. When the flux is evaporated in this state, the concentration of the flux decreases, that is, the effect of the flux of decreasing the melting point of the solute is reduced, and thus, the evaporation of the flux serves as a driving force to cause the crystal growth of the solute (flux evaporation method). Note that the crystal growth of the solute can also be caused by cooling the liquid phase of the solute and the flux (slow cooling method) .

With the flux method, the crystal growth can be achieved at a temperature much lower than a melting point, the crystal structure can be precisely controlled, and a crystal body having a euhedral shape can be formed. These are examples of advantages of the flux method.

Probably, in the production of niobate particles with the use of the flux method, in instances where the niobium compound is fired in the presence of a potassium compound and/or a sodium compound, a portion of the potassium compound and/or the sodium compound forms oxides ($Na_2O$ and/or $K_2O$), which serve as flux to enable the progression of the crystal growth of the niobate particles.

Furthermore, probably, in instances where the niobium compound is fired in the presence of potassium carbonate and/or sodium carbonate, a portion of the potassium carbonate and/or the sodium carbonate forms oxides ($Na_2O$ and/or $K_2O$) and/or $CO_2$, and these oxides and/or $CO_2$ serve as flux to enable the progression of the crystal growth of the niobate particles.

The mechanism by which the niobate particles are produced in the instance in which a molybdenum compound is used as flux is not necessarily clear. Probably, the mechanism is, for example, as follows. Specifically, when a niobium compound is fired in the presence of a molybdenum compound, a portion of the niobium compound forms niobium molybdate, and the molybdenum compound forms one or more molybdates (e.g., $K_aMo_bO_c$, $Na_aMo_bO_c$, and $K_aNa_{a'}Mo_bO_c$). In this process, the function of the molybdate as flux enables the crystal of the niobate to grow at a temperature lower than the melting point of the niobate, as will be appreciated from the description above. Furthermore, for example, the niobium molybdate fraction that has been formed is decomposed, which promotes the crystal growth of the niobate particles. That is, while the molybdenum compound (a molybdate) serves as flux, the niobate particles are produced via the niobium molybdate, which is an intermediate product.

The mechanism described above also occurs in instances in which a niobium compound and a tantalum compound, rather than a niobium compound, are fired.

The firing may be performed by any method, which may be a method known in the art. Presumably, in the instance where a molybdenum compound is used, when the firing temperature exceeds 500°C, a portion of the niobium compound and the tantalum compound reacts with the molybdenum compound to form niobium molybdate and the like, and the molybdenum compound forms one or more molybdates ($K_aMo_bO_c$, $Na_aMo_bO_c$, and $K_aNa_{a'}Mo_bO_c$). Furthermore, presumably, when the firing temperature reaches 800°C or greater, the niobium molybdate fraction and the like that have been formed are decomposed, and the molybdate serves as flux to form the niobate particles. Furthermore, presumably, regarding the niobate particles, a molybdenum compound is incorporated into the niobate particles during the processes of the decomposition of the niobium molybdate and the crystal growth of the particles.

Furthermore, the states of the niobium compound, the tantalum compound, the molybdenum compound, the sodium compound, the potassium compound, and the like that can be used in the firing are not particularly limited, and it is sufficient that the raw material compounds, namely, the molybdenum compound, the niobium compound, the tantalum compound, the sodium compound, the potassium compound, and the like be present in the same space in which the raw material compounds can act on one another. Specifically, any of the following forms of mixing may be employed: simple mixing in which powders of the raw material compounds are mixed together, mechanical mixing that uses a mill or the like, and mixing that uses a mortar or the like; and the mixing may be performed in a dry state or a wet state.

The conditions of the firing temperature are not particularly limited and are appropriately selected in consideration of the target particle size of the niobate particles, the formation of a molybdenum compound in the niobate particles, the shape of the niobate particles, and the like. The firing temperature may be 700°C or greater, which is close to the temperature at which a molybdate can serve as flux. The firing temperature may be 750°C or greater, 800°C or greater, 850°C or greater, or 900°C or greater.

From the standpoint of efficiently producing niobate particles having an improved crystallite size, it is preferable that the firing temperature be 800°C or greater. The firing temperature is more preferably 900°C or greater and even more preferably 1000°C or greater.

In general, controlling the shape of the niobate that results from firing requires the implementation of high-temperature firing at greater than 1500°C, which is close to the melting point of niobium oxide. Industrial application of such high-temperature firing involves significant problems in terms of the load on the firing furnace and the fuel cost.

With an embodiment of the present invention, the formation of niobate particles can be achieved efficiently and at low cost even under conditions in which, for example, a maximum firing temperature for firing the niobium compound is less than or equal to 1500°C.

Furthermore, with the method of this embodiment for producing niobate particles, it is possible to form niobate particles having a euhedral shape regardless of the shape of the precursors, even at a firing temperature of 1300°C or less, which is a temperature much lower than the melting point of niobium oxide. Furthermore, from the standpoint of efficiently producing the niobate particles, it is preferable that the firing temperature be 1200°C or less. More preferably, the firing temperature is 1100°C or less.

A range of the value of the firing temperature for firing the niobium compound in the firing step may be, for example, 700 to 1300°C, 750 to 1300°C, 800 to 1200°C, 850 to 1200°C, 900 to 1100°C, or 1000 to 1100°C.

A heating rate may be specified to be 20 to 600°C/h, 40 to 500°C/h, or 80 to 400°C/h, from the standpoint of production efficiency.

Regarding the time of firing, it is preferable that the heating time for increasing the temperature to a predetermined firing temperature be within a range of 15 minutes to 10 hours, and a holding time for holding at the firing temperature be within a range of 5 minutes to 30 hours. In terms of achieving efficient formation of the niobate particles, it is preferable that the holding time associated with the firing temperature be 2 hours or more, and it is more preferable that the holding time associated with the firing temperature be 2 to 15 hours.

By selecting the conditions of a firing temperature of 700 to 1100°C and a holding time associated with the firing temperature of 2 to 15 hours, niobate particles having an improved crystallite size can be readily obtained.

Atmospheres for the firing are not particularly limited as long as the effects of the present invention can be produced. For example, an oxygen-containing atmosphere, such as air or oxygen, or an inert atmosphere, such as nitrogen, argon, or carbon dioxide, is preferable, and, if cost is taken into consideration, an air atmosphere is more preferable.

Apparatuses for performing the firing are also not necessarily limited, and a so-called firing furnace may be used. Preferably, the firing furnace is formed of a material that does not react with sublimed molybdenum oxide, and further preferably, the firing furnace is highly gas-tight so that the molybdenum oxide can be efficiently used.

[Cooling Step]

The method for producing niobate particles may include a cooling step. The cooling step is a step of cooling the niobate particles that have undergone crystal growth in the firing step.

A cooling rate is not particularly limited and is preferably 1 to 1000°C/hour, more preferably 5 to 500°C/hour, and even more preferably 50 to 100°C/hour. When the cooling rate is 1°C/hour or greater, a production time can be shortened, and, accordingly, such a cooling rate is preferable. When the cooling rate is 1000°C/hour or less, cracking of a firing crucible due to heat shock does not occur frequently, that is, the firing crucible can be used for a long time, and, accordingly, such a cooling rate is preferable.

The cooling may be performed by any method, which may be natural cooling or may involve the use of a cooling device.

[Aftertreatment Step]

The production method of this embodiment may include an aftertreatment step. The aftertreatment step may be a step of separating the niobate particles from the fluxing agent, both being in the fired product, and the separating may be performed after the fired product is removed from the firing crucible. The aftertreatment step may be performed after the firing step described above. The aftertreatment step may be repeatedly performed, twice or more, as necessary.
Examples of methods for removing the fluxing agent include washing and high-temperature treatment. These may be used in combination.
Examples of methods for the washing include, but are not limited to, water washing provided that the flux is water-soluble, as are the above-described potassium compound, sodium compound, and molybdate compound.
Examples of methods for the high-temperature treatment include a method in which the temperature is increased to a temperature greater than or equal to the sublimation point or the boiling point of the flux.

[Grinding Step]

In some cases, the fired product resulting from the firing step may include aggregates of niobate particles, and, consequently, a particle size range suitable for applications that are being considered may not be satisfied. Accordingly, if necessary, the niobate particles may be ground so that a suitable particle size range can be satisfied.
The grinding of the fired product may be performed by any method, which may be a method known in the art that uses a ball mill, a jaw crusher, a jet mill, a disc mill, a SpectroMill, a grinder, a mixer mill, or the like.

[Size Classification Step]

The fired product including niobate particles that has been produced by the firing step may be subjected to a size classification process when appropriate, so that the particle size range can be adjusted. The term "size classification process" refers to an operation of sorting particles by particle size.
The size classification may be wet classification or dry classification, but, from the standpoint of productivity, dry classification is preferable. The dry classification may be classification using a sieve or may be, for example, air classification, in which classification is performed by using a difference between the centrifugal force and the fluid drag. From the standpoint of classification accuracy, air classification is preferable, and the air classification may be performed by using a classifier, such as an air sifter that utilizes a Coanda effect, a swirling airflow type classifier, a forced vortex centrifugal classifier, or a semi-free vortex centrifugal classifier.
The grinding step and the size classification step described above may be performed at stages where the steps are necessary. By selecting whether or not to perform the grinding and/or the size classification and/or selecting conditions for the steps, it is possible, for example, to adjust the average particle size of the resulting niobate particles.
The niobate particles of the above embodiment or the niobate particles produced by the production method of this embodiment may have few aggregates or no aggregates. This is preferable because in such a case, their inherent properties can be easily exhibited, handleability thereof is enhanced, and, in an instance where the niobate particles are used by being dispersed in a dispersion medium, enhanced dispersibility is exhibited.
Note that with the method of this embodiment for producing niobate particles, niobate particles having few aggregates or no aggregates can be readily produced; therefore, the method has an excellent advantage of producing, with high productivity, niobate particles having desired excellent properties, without having to perform the grinding step or the size classification step.

<<Resin Composition>>

The niobate particles of the above embodiment can be provided as a resin composition by being combined with a resin. According to an embodiment, a resin composition including the niobate particles of the above embodiment and a resin is provided.
The resin may be any resin and may be a polymer, an oligomer, or a monomer. The resin may be a thermosetting resin, a thermoplastic resin, or an actinic radiation curable resin.

(Thermosetting Resin)

A thermosetting resin is a resin having a property of being able to become substantially insoluble and infusible when the resin is cured by a means, such as heating, radiation, or a catalyst. For example, the resin may be a resin known in the art that is used in a molding material or the like. Specific examples thereof include phenolic resins, such as novolac-type phenolic resins and resole-type phenolic resins, where examples of the novolac-type phenolic resins include phenol novolac resins and cresol novolac resins, and examples of the resole-type phenolic resins include unmodified resole phenolic resin and oil-modified resole phenolic resins modified with tung oil, linseed oil, walnut oil, or the like; epoxy resins, such as bisphenol-type epoxy resins, aliphatic chain-modified bisphenol-type epoxy resins, novolac-type epoxy resins, biphenyl-type epoxy resins, and polyalkylene glycol-type epoxy resins, where examples of the bisphenol-type epoxy resins include bisphenol A epoxy resins and bisphenol F epoxy resins, and examples of the novolac-type epoxy resins include novolac epoxy resins and cresol novolac epoxy resins; urea resins; triazine ring-containing resins, such as melamine resins; vinyl resins, such as (meth)acrylic resins and vinyl ester resins; unsaturated polyester resins; bismaleimide resins; polyurethane resins; diallyl phthalate resins; silicone resins; benzoxazine ring-containing resins; and cyanate ester resins; each of these may be a polymer, an oligomer, or a monomer.

The thermosetting resins mentioned above may be used with a curing agent. The curing agent that is used and the thermosetting resin may be in a combination known in the art. For example, in instances where the thermosetting resin is an epoxy resin, any compound commonly used as a curing agent may be used, and examples of the compound include amine-based compounds, amide-based compounds, acid anhydride-based compounds, and phenolic compounds. Specifically, examples of the amine-based compounds include diaminodiphenylmethane, diethylenetriamine, triethylenetetramine, diaminodiphenyl sulfone, isophoronediamine, imidazole, $BF_3$-amine complexes, and guanidine derivatives. Examples of the amide-based compounds include dicyandiamide and polyamide resins synthesized from a linolenic acid dimer and ethylenediamine. Examples of the acid anhydride-based compounds include phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, and methylhexahydrophthalic anhydride. Examples of the phenolic compounds include phenol novolac resins, cresol novolac resins, aromatic hydrocarbon formaldehyde resin-modified phenolic resins, dicyclopentadiene phenol adduct-type resins, phenol aralkyl resins (xylok resins), polyphenolic novolac resins, typified by resorcin novolac resins, that are synthesized from a polyhydroxy compound and formaldehyde, naphthol aralkyl resins, trimethylolmethane resins, tetraphenylolethane resins, naphthol novolac resins, naphthol-phenol co-condensed novolac resins, naphthol-cresol co-condensed novolac resins, biphenyl-modified phenolic resins (polyphenolic compounds in which phenol nuclei are interconnected by a bismethylene group), biphenyl-modified naphthol resins (polynaphtholic compounds in which phenol nuclei are interconnected by a bismethylene group), and polyhydric phenol compounds such as aminotriazine-modified phenolic resins (polyphenolic compounds in which phenol nuclei are interconnected by melamine, benzoguanamine, or the like) and alkoxy-group-containing aromatic ring-modified novolac resins (polyphenolic compounds in which phenol nuclei and alkoxy-group-containing aromatic rings are interconnected by formaldehyde). These curing agents may be used alone or in a combination of two or more.

In the resin composition of this embodiment, amounts of the thermosetting resin and the curing agent are not particularly limited. As an example, when the thermosetting resin is an epoxy resin, the amounts may be such that 0.7 to 1.5 equivalents of an active group of the curing agent is present based on 1 equivalent of the total epoxy groups of the epoxy resin. With such amounts, the resulting cured product has good properties, and, therefore, such amounts are preferable.

Furthermore, in the resin composition of this embodiment, a curing accelerator may be appropriately used with the thermosetting resin, if necessary. When the curable resin is an epoxy resin, for example, any of a variety of curing accelerators may be used. Examples of the curing accelerators include phosphorus compounds, tertiary amines, imidazoles, metal salts of an organic acid, Lewis acids, and amine complex salts.

Furthermore, if necessary, a curing catalyst may be timely used with the thermosetting resin, if necessary. Examples of the curing catalyst include thermal polymerization initiators and actinic radiation polymerization initiators that are known in the art.

(Thermoplastic Resin)

The thermoplastic resin that may be used in the resin composition of this embodiment may be a resin known in the art that is used in a molding material or the like. Specific examples thereof include polyethylene resins, polypropylene resins, polymethylmethacrylate resins, polyvinyl acetate resins, ethylene-propylene copolymers, ethylene-vinyl acetate copolymers, polyvinyl chloride resins, polystyrene resins, polyacrylonitrile resins, polyamide resins, polycarbonate resins, polyacetal resins, polyethylene terephthalate resins, polyphenylene oxide resins, polyphenylene sulfide resins, polysulfone reins, polyethersulfone resins, polyetheretherketone resins, polyallyl sulfone resins, thermoplastic polyimide resins, thermoplastic urethane resins, polyamino bismaleimide resins, polyamide-imide resins, polyetherimide resins, bismaleimide triazine resins, polymethylpentene resins, fluorinated resins, liquid crystal polymers, olefin-vinyl alcohol copolymers, ionomer resins, polyarylate resins, acrylonitrile-ethylene-styrene copolymers, acrylonitrile-butadiene-styrene copolymers, and acrylonitrile-styrene copolymers. At least one thermoplastic resin may be selected and used, or two or more thermoplastic resins may be used in combination, depending on a purpose.

In instances where the resin composition is provided for piezoelectric element applications, it is preferable that the resin exhibit a high dielectric constant and that the resin be a polymer containing an electron-withdrawing group. Preferred examples of the polymer include fluorine-containing polymers, such as polyvinylidene fluoride (PVDF), vinylidene fluoride-tetrafluoroethylene copolymers, and vinylidene fluoride-trifluoroethylene copolymers; and cyano group- or cyanoethyl group-containing polymers, such as cyanoethylated polyvinyl alcohols, vinylidene cyanide-vinyl acetate copolymers, cyanoethyl cellulose, cyanoethyl hydroxy saccharose, cyanoethyl hydroxy cellulose, cyanoethyl hydroxy pullulan, cyanoethyl methacrylate, cyanoethyl acrylate, cyanoethyl hydroxy ethyl cellulose, cyanoethyl amylose, cyanoethyl hydroxy propyl cellulose, cyanoethyl dihydroxy propyl cellulose, cyanoethyl hydroxy propyl amylose, cyanoethyl polyacryl amide, cyanoethyl polyacrylate, cyanoethyl pullulan, cyanoethyl polyhydroxy methylene, cyanoethyl glycidol pullulan, cyanoethyl saccharose, and cyanoethyl sorbitol.

The resin composition of this embodiment may contain one or more additives if necessary. Any of the following additives may be added within a range in which the effects of the invention can be produced: external lubricants, internal lubricants, antioxidants, flame retardants, light stabilizers, UV absorbers, silane-based, titanate-based, or aluminate-based coupling agents, reinforcing materials such as glass fibers and carbon fibers, fillers, various coloring agents, and the like. It is also possible to use a stress reducing agent (stress relieving agent), examples of which include butadiene copolymer rubbers and silicone-based compounds, such as silicone oils, liquid rubbers, rubber powders, methyl acrylate-butadiene-styrene copolymers, and methyl methacrylate-butadiene-styrene copolymers.

The resin composition of this embodiment can be obtained by mixing the niobate particles of the above embodiment, a resin, and, if necessary, one or more additives together. Methods for the mixing are not particularly limited, and the mixing is performed by a method known in the art.

When the resin is a thermosetting resin, typical methods are as follows. In one method, a thermosetting resin, the niobate particles of the above embodiment, and, if necessary, one or more other components are thoroughly mixed together in a mixer or the like, and subsequently, the mixture is kneaded in a three-roll mill, to give a flowable liquid composition. In another method, a predetermined amount of a thermosetting resin, the niobate particles of the above embodiment, and, if necessary, one or more other components are thoroughly mixed together in a mixer or the like, subsequently, the mixture is melt-kneaded with a mixing roll, an extrusion apparatus, or the like, and the resultant is cooled, to give a solid composition. Regarding a state of the mixing, in instances where a curing agent, a catalyst, and/or the like are added, it is preferable that the additives be sufficiently uniformly mixed with the curable resin, and it is more preferable that the niobate particles of the above embodiment be also uniformly dispersed and mixed.

When the resin is a thermoplastic resin, a typical method is a method in which a thermoplastic resin, the niobate particles of the above embodiment, and, if necessary, one or more other components are preliminarily mixed together in any of a variety of mixers, such as a tumbler or a Henschel mixer, and subsequently, the mixture is melt-kneaded in a mixer, such as a Banbury mixer, a roll, a Brabender mixer, a single screw kneading and extrusion apparatus, a twin screw kneading and extrusion apparatus, a kneader, or a mixing roll. A temperature for the melt-kneading is not particularly limited and may be within a range of 240 to 320°C.

For the preparation of the resin composition of this embodiment, a mixing ratio between the niobate particles of the above embodiment and a non-volatile portion of the resin is not particularly limited and may be a ratio in which, for example, the niobate particles are present in an amount within a range of 0.1 to 1800 parts, or 10 to 900 parts, per 100 parts of the non-volatile portion of the resin on a mass basis.

A content ratio of the niobate particles to the total mass (100 mass%) of the resin composition of this embodiment may be 30 mass% or greater, 50 to 90 mass%, or 60 to 85 mass%.

<<Molded Article>>

A molded article can be obtained by molding the resin composition of the above embodiment. According to an embodiment, a molded article molded from the resin composition of the above embodiment is provided. The resin molded article can be obtained by using a method known in the art.

When the resin to be included in the resin composition is, for example, a thermosetting resin, a common curing method for a thermosetting resin composition, such as an epoxy resin composition, may be employed. For example, in the case of a resin composition containing an epoxy resin as the resin, the curing can be accomplished by heat. Heating temperature conditions therefor can be appropriately selected in accordance with the type of the curing agent that is used in combination, applications, and the like, and the heating can be performed at a temperature within an approximate range of room temperature to 250°C. In the case of an actinic radiation curable resin, cure molding can be accomplished by irradiation with actinic radiation, such as UV radiation or infrared radiation.

In the instance where the resin of the above embodiment is a thermoplastic resin, a molding method known in the art can also be used to produce the molded article. Examples include injection molding methods, ultra-high-speed injection molding methods, injection compression molding methods, two-color molding methods, blow molding methods, such as gas-assisted molding, molding methods using an insulated mold, molding methods using a rapidly heated mold, foam molding (including supercritical fluid foam molding), insert molding, IMC molding methods (in-mold coating molding), extrusion molding methods, sheet molding methods, rotational molding methods, lamination molding methods, and press molding methods. A molding method that uses a hot runner technique may be employed. A shape, a pattern, a color, dimensions, and the like of the molded article are not limited and can be selected as desired, in accordance with the application of the molded article.

In instances where the molded article of the resin composition is in the form of a sheet or a layer, a thickness thereof may be 10 to 100 $\mu$m or 10 to 80 $\mu$m.

The resin composition of the above embodiment and the molded article of the resin composition can be provided and used as a piezoelectric element by being appropriately polarized.

EXAMPLES

The present invention will now be described in more detail with reference to Examples. Note that the present invention is not limited to the Examples described below.

<Analysis and Evaluation>

The following measurements were performed by using powders of Examples and a Comparative Example as samples.

[XRF (X-ray fluorescence) Analysis]

Approximately 70 mg of each of the sample powders was placed on filter paper and covered with a PP film and was then subjected to an XRF (X-ray fluorescence) analysis, which was performed with an X-ray fluorescence spectrometer PrimusIV (manufactured by Rigaku Corporation). The conditions for the analysis were as follows. Measurement conditions

EZ scan mode
Measured elements: F to U
Measurement time: standard
Measurement diameter: 10 mm
Residue component (balance component): none

XRF analysis was performed on the sample powder to determine a content of niobium of the sample powder, and then, the content percentage (mass%) calculated as $Nb_2O_5$, based on the total mass of the sample powder taken as 100 mass%, was calculated. XRF analysis was performed on the sample powder to determine a content of tantalum of the sample powder, and then, the content percentage (mass%) calculated as $Ta_2O_5$, based on the total mass of the sample powder taken as 100 mass%, was calculated.

XRF analysis was performed on the sample powder to determine a content of molybdenum of the sample powder, and then, the content percentage (mass%) calculated as $MoO_3$, based on the total mass of the sample powder taken as 100 mass%, was calculated.

XRF analysis was performed on the sample powder to determine a content of potassium of the sample powder, and then, the content percentage (mass%) calculated as $K_2O$, based on the total mass of the sample powder taken as 100 mass%, was calculated. XRF analysis was performed on the sample powder to determine a content of sodium of the sample powder, and then, the content percentage (mass%) calculated as $Na_2O$, based on the total mass of the sample powder taken as 100 mass%, was calculated.

[Analysis of Crystal Structure: XRD (X-ray diffraction) Method]

The sample powder was loaded into a measurement sample holder having a depth of 0.5 mm, which was then placed in a wide-angle X-ray diffractometer (XRD) (Ultima IV, manufactured by Rigaku Corporation), and a measurement was performed under the following conditions: Cu-K$\alpha$ radiation, 40 kV/40 mA, a scanning speed of 2°/min, and a scanning range of 10 to 70° or a scanning range of 10 to 90°.

[Calculation of x by Shifting XRD]

In the case of $K_xNa_{(1-x)}NbO_3$, which did not contain Ta, the XRD peak position was compared against data provided in a report (Bo-Ping Zhang et al. J. Am. Ceram. Soc., 89 [5] 1605-1609 (2006)), and the composition x was determined by interpolation.

[Measurement of Particle Size]

(In the instance of particles having a cubic shape)

Images of the sample powder were acquired with a scanning electron microscope (SEM). Regarding the smallest unit particle (i.e., primary particle) that was identifiable in the two-dimensional images, in the instance where the particle was recognized as having a cubic shape, the length of a side of the hexahedron as determined from a particle image of a primary particle was measured as the particle size.

The same operation was performed on 50 primary particles, and an average of the measurements was determined.

[Measurement of Crystallite Size]

A measurement was performed as follows. The X-ray diffractometer used was a SmartLab (manufactured by Rigaku Corporation), the detector used was a high-intensity high-resolution crystal analyzer (CALSA), and the analysis software used was PDXL. The measurement mode was the $2\theta/\theta$ mode, and the average crystallite size was calculated from the full widths at half maximum of the peak appearing at $2\theta=23.0°\pm1.0°$, the peak appearing at $2\theta=32.0°\pm1.2°$, and the peak appearing at $2\theta=57.0°\pm1.0°$, by using the Scherrer equation. The measurement conditions were as follows: a scanning speed of 0.05°/min, a scanning range of 20 to 70°, a step of 0.002°, and an instrument standard broadening of 0.028° (Si).

[Measurement of Particle Size Distribution]

The particle size distribution of the sample powder was measured in a dry state with a dry laser-diffraction particle size distribution analyzer (HELOS (H3355) & RODOS, manufactured by Japan Laser Corporation) under conditions including a dispersion pressure of 3 bar and a suction pressure of 90 mbar. The particle size at a point at which the distribution curve of the cumulative volume percentage intersected the horizontal axis located at 50% was determined as the $D_{50}$. The particle size at a point at which the distribution curve of the cumulative volume percentage intersected the horizontal axis located 10% away from the small particle side was determined as the $D_{10}$. The particle size at a point at which the distribution curve of the cumulative volume percentage intersected the horizontal axis located 90% away from the small particle side was determined as the $D_{90}$.

[Measurement of Specific Surface Area]

The specific surface area of the sample powder was determined as follows. A measurement was performed with a specific surface area analyzer (Belsorp-mini, manufactured by MicrotracBEL), and the specific surface area ($m^2$/g) was calculated as a surface area per gram of the sample, which was measured from an amount of adsorption of nitrogen gas in accordance with a BET method.

<1. Production of $K_xNa_{(1-x)}Nb_yTa_{(1-y)}O_3$ Particles>

[Example 1]

A mixture was prepared by mixing 10.0 g of niobium oxide ($Nb_2O_5$, a reagent manufactured by Kanto Chemical Co., Inc.), 6.8 g of molybdenum oxide ($MoO_3$, a reagent manufactured by Kanto Chemical Co., Inc.), 7.53 g of potassium carbonate ($K_2CO_3$, a reagent manufactured by Kanto Chemical Co., Inc.), and 4.0 g of sodium carbonate ($Na_2CO_3$, a reagent manufactured by Kanto Chemical Co., Inc.) together in a mortar. The resulting mixture was placed in a crucible and fired in a ceramic electric furnace at 1100°C for 10 hours. After cooling, the crucible was removed from the ceramic electric furnace.

Subsequently, the resulting fired product was ultrasonically cleaned with water five times, and thereafter, the resultant was subjected to water washing, which used filtration to remove the wash water, and was then dried. Thus, the remaining fluxing agent was removed to afford 10.8 g of a powder of Example 1.

The synthesis conditions are shown in Table 1.

[Table 1]

| | Synthesis | | | | | | | | | |
|---|---|---|---|---|---|---|---|---|---|---|
| | Raw Materials | | | | | Amount of Fluxing Agents* | (K+Na)/ (Nb+Ta) | (K+Na)/ Mo | K/Na | Firing Conditions |
| | $Nb_2O_5$ | $Ta_2O_5$ | $MoO_3$ | $K_2CO_3$ | $Na_2CO_3$ | | | | | |
| | g | g | g | g | g | parts by mass | molar ratio | molar ratio | molar ratio | °C |
| Example 1 | 10 | - | 6.8 | 7.53 | 4 | 183.3 | 2.45 | 1.95 | 1.44 | 1100 |
| Example 2 | 10 | - | 6.8 | 7.53 | 4 | 183.3 | 2.45 | 1.95 | 1.44 | 1000 |
| Example 3 | 10 | - | 6.8 | 7.53 | 4 | 183.3 | 2.45 | 1.95 | 1.44 | 900 |
| Example 4 | 10 | - | 6.8 | 7.53 | 4 | 183.3 | 2.45 | 1.95 | 1.44 | 800 |
| Example 5 | 10 | - | 6.8 | 7.53 | 4 | 183.3 | 2.45 | 1.95 | 1.44 | 700 |
| Example 6 | 10 | - | 6.8 | - | 10 | 168 | 2.51 | 2.00 | - | 1000 |
| Example 7 | 10 | - | 6.8 | 13.2 | - | 200 | 2.54 | 2.02 | - | 1000 |
| Example 8 | 8.4 | 1.6 | 6.8 | 7.53 | 4 | 183.3 | 2.62 | 1.95 | 1.44 | 1000 |
| Example 9 | 7.7 | 2.3 | 6.8 | 7.53 | 4 | 183.3 | 2.70 | 1.95 | 1.44 | 1000 |
| Example 10 | 7.1 | 2.9 | 6.8 | 7.53 | 4 | 183.3 | 2.77 | 1.95 | 1.44 | 1000 |
| Example 11 | 5.8 | 4.2 | 6.8 | 7.53 | 4 | 183.3 | 2.95 | 1.95 | 1.44 | 1000 |
| Example 12 | 3.7 | 6.3 | 6.8 | 7.53 | 4 | 183.3 | 3.27 | 1.95 | 1.44 | 1000 |
| Example 13 | 3.7 | 6.3 | - | 7.53 | 4 | 115.3 | 3.27 | - | 1.44 | 1000 |
| Comparative Example 1 | - | - | - | - | - | - | - | - | - | - |
| * Total parts by mass of $MoO_3$, $K_2CO_3$, and $Na_2CO_3$ per 100 parts by mass of the total mass of $Nb_2O_5$ and $Ta_2O_5$ | | | | | | | | | | |

[Examples 2 to 13]

Powders of Examples 2 to 13 were prepared by performing the same operation as that of Example 1, except that the proportions of the raw material compounds and the firing temperature were changed from those of Example 1 as shown in Table 1.
The raw material $Ta_2O_5$ listed in Table 1 was tantalum oxide ($Ta_2O_5$, a reagent manufactured by Kanto Chemical Co., Inc.).

[Comparative Example 1]

Commercially available sodium potassium niobate (manufactured by Nippon Chemical Industrial Co., Ltd.) was used as a powder of Comparative Example 1.

<Results>

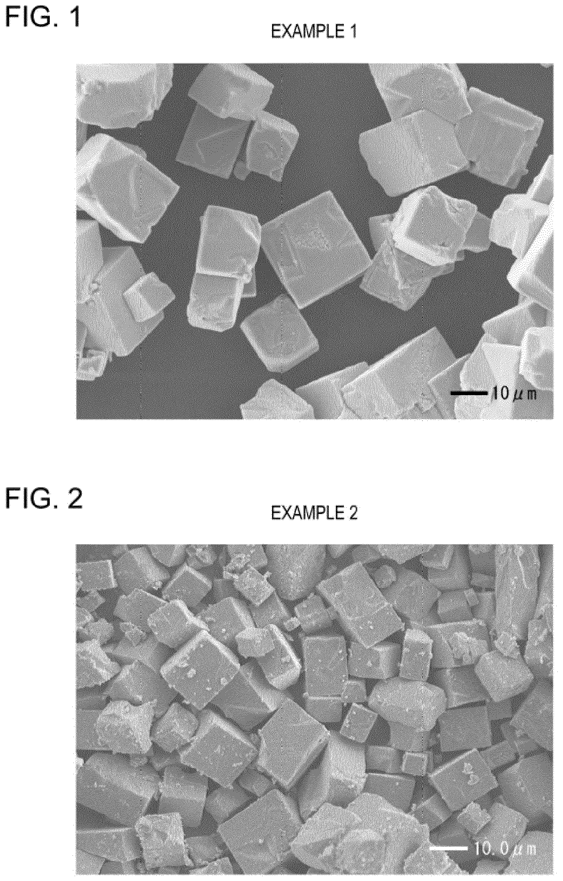

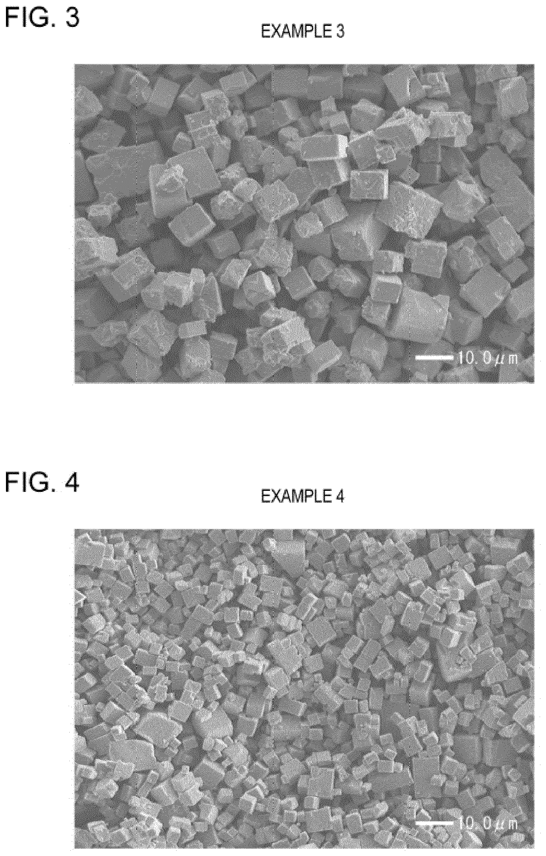

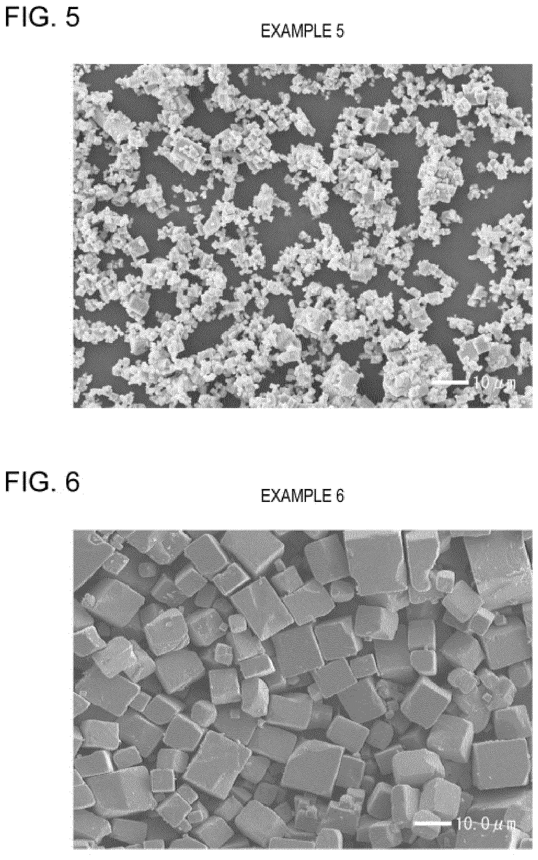

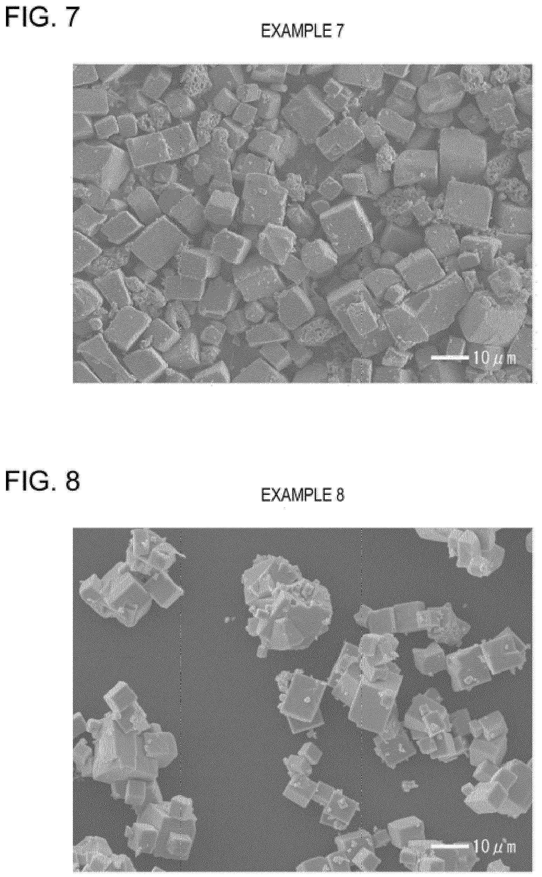

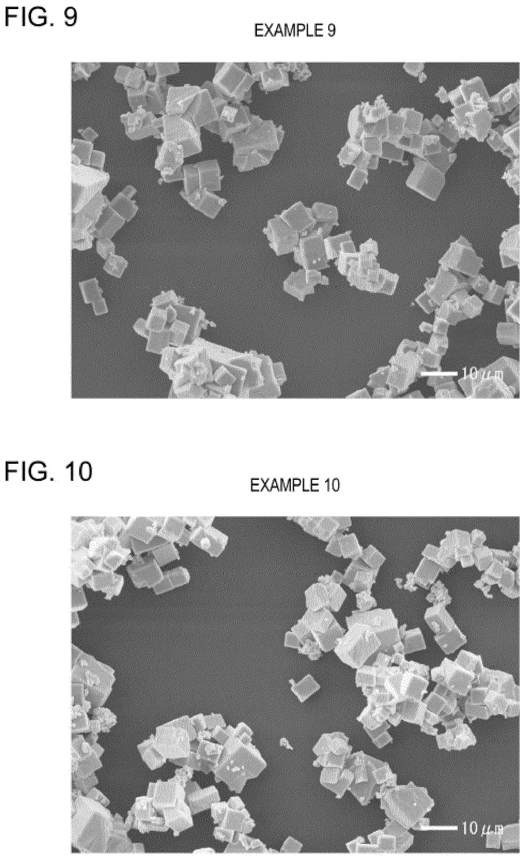

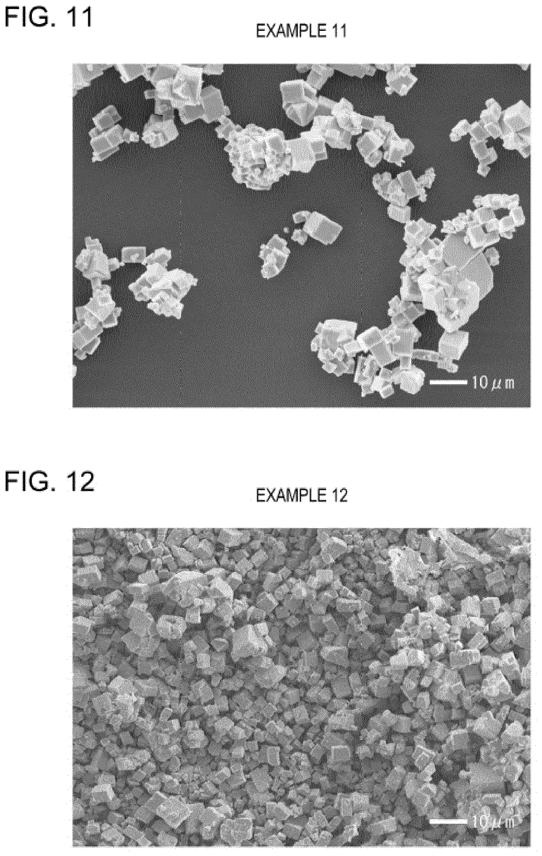

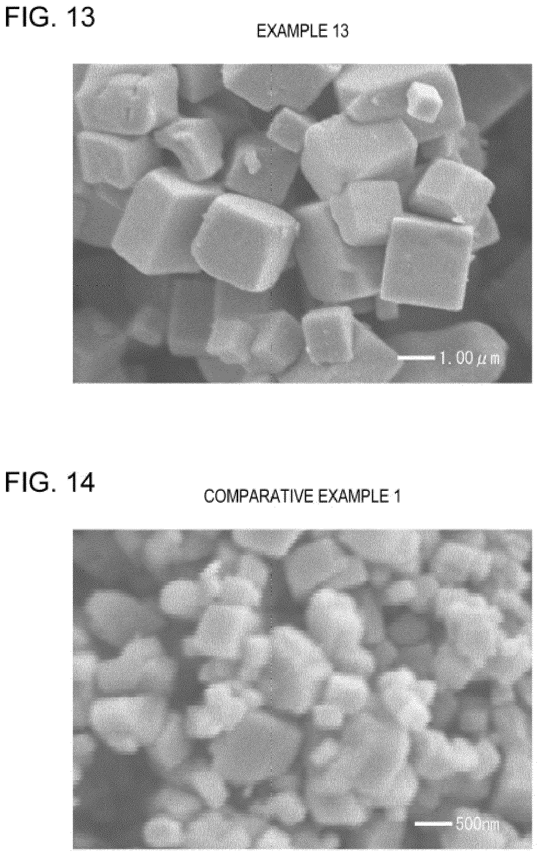

SEM images of the powders of Examples 1 to 13 and Comparative Example 1 are shown in Figs. 1 to 14.
The results of the evaluations described above are shown in Table 2. The symbol "-" indicates that the compound was not used. "N.D." is an abbreviation of "not detected" and indicates that the compound was not detected.

## [Table 2]

<table>
<tr><td colspan="21" align="center">$K_xNa_{1-x}Nb_yTa_{1-y}O_3$</td></tr>
<tr><td colspan="21" align="center">Evaluations</td></tr>
<tr><td></td><td colspan="6">XRF</td><td colspan="2">XRD</td><td>SEM</td><td></td><td colspan="3">Crystallite Size</td><td colspan="3">Particle Size</td><td>BET Specific Surface Area</td><td>Percent Yield of Particles</td></tr>
<tr><td></td><td>Nb₂O₅</td><td>Ta₂O₅</td><td>MoO₃</td><td>K₂O</td><td>Na₂O</td><td>y</td><td>R</td><td>x by XRD</td><td>Shape</td><td>Size</td><td>22-24°</td><td>30.8-33.2°</td><td>56-58°</td><td>D10</td><td>D50</td><td>D90</td><td></td><td></td></tr>
<tr><td></td><td>mass%</td><td>mass%</td><td>mass%</td><td>mass%</td><td>mass%</td><td></td><td></td><td></td><td></td><td>μm</td><td>nm</td><td>nm</td><td>nm</td><td>μm</td><td>μm</td><td>μm</td><td>m²/g</td><td>mass%</td></tr>
<tr><td>Example 1</td><td>87.1</td><td>N.D.</td><td>N.D.</td><td>5.58</td><td>7.19</td><td>1</td><td>13.3</td><td>0.23</td><td>Cubic</td><td>40</td><td>205</td><td>189</td><td>138</td><td>15.8</td><td>33.6</td><td>57.7</td><td>0.12</td><td>94</td></tr>
<tr><td>Example 2</td><td>86.6</td><td>N.D.</td><td>N.D.</td><td>6.01</td><td>7.31</td><td>1</td><td>24.5</td><td>0.25</td><td>Cubic</td><td>25</td><td>222</td><td>177</td><td>159</td><td>7.2</td><td>18.7</td><td>36.8</td><td>0.22</td><td>94</td></tr>
<tr><td>Example 3</td><td>88</td><td>N.D.</td><td>0.06</td><td>6.9</td><td>4.9</td><td>1</td><td>9.3</td><td>0.16</td><td>Cubic</td><td>15</td><td>146</td><td>158</td><td>100</td><td>6.1</td><td>12.7</td><td>26.3</td><td>0.31</td><td>93</td></tr>
<tr><td>Example 4</td><td>85.5</td><td>N.D.</td><td>0.11</td><td>7.07</td><td>7.29</td><td>1</td><td>13.4</td><td>0.25</td><td>Cubic</td><td>10</td><td>135</td><td>136</td><td>30</td><td>2.4</td><td>5.8</td><td>14.9</td><td>0.46</td><td>96</td></tr>
<tr><td>Example 5</td><td>82.1</td><td>N.D.</td><td>0.38</td><td>6.52</td><td>11</td><td>1</td><td>1.1</td><td>0.24</td><td>Cubic</td><td>1</td><td>81</td><td>20</td><td>11</td><td>0.8</td><td>2.4</td><td>6.0</td><td>0.99</td><td>81</td></tr>
<tr><td>Example 6</td><td>89</td><td>N.D.</td><td>0.18</td><td>N.D.</td><td>10.8</td><td>1</td><td>18.5</td><td>0</td><td>Cubic</td><td>20</td><td>442</td><td>640</td><td>288</td><td>5.2</td><td>11.6</td><td>23.6</td><td>0.29</td><td>93</td></tr>
<tr><td>Example 7</td><td>77.6</td><td>N.D.</td><td>N.D.</td><td>21.8</td><td>N.D.</td><td>1</td><td>3.6</td><td>1</td><td>Cubic</td><td>15</td><td>380</td><td>239</td><td>227</td><td>5.3</td><td>12.6</td><td>26.5</td><td>0.32</td><td>88</td></tr>
<tr><td>Example 8</td><td>73.1</td><td>15.4</td><td>0.1</td><td>4.95</td><td>6.39</td><td>0.89</td><td>1.1</td><td>-</td><td>Cubic</td><td>15</td><td>282</td><td>280</td><td>145</td><td>5.2</td><td>13.0</td><td>34.7</td><td>0.19</td><td>89</td></tr>
<tr><td>Example 9</td><td>65.9</td><td>23.1</td><td>0.17</td><td>5.03</td><td>5.68</td><td>0.83</td><td>1.1</td><td>-</td><td>Cubic</td><td>10</td><td>241</td><td>129</td><td>223</td><td>4.4</td><td>12.1</td><td>31.4</td><td>0.31</td><td>86</td></tr>
<tr><td>Example 10</td><td>59.6</td><td>29.5</td><td>0.15</td><td>4.49</td><td>6.15</td><td>0.77</td><td>2.4</td><td>-</td><td>Cubic</td><td>5</td><td>245</td><td>149</td><td>66</td><td>4.4</td><td>11.6</td><td>29.8</td><td>0.27</td><td>84</td></tr>
<tr><td>Example 11</td><td>44.8</td><td>45.1</td><td>0.2</td><td>4.23</td><td>5.52</td><td>0.62</td><td>2.3</td><td>-</td><td>Cubic</td><td>5</td><td>119</td><td>121</td><td>103</td><td>3.4</td><td>8.9</td><td>20.8</td><td>0.28</td><td>80</td></tr>
<tr><td>Example 12</td><td>21.2</td><td>70.6</td><td>N.D.</td><td>2.76</td><td>5.3</td><td>0.33</td><td>3.4</td><td>-</td><td>Cubic</td><td>5</td><td>112</td><td>116</td><td>75</td><td>2.7</td><td>6.7</td><td>17.8</td><td>0.45</td><td>81</td></tr>
<tr><td>Example 13</td><td>12.3</td><td>76</td><td>N.D.</td><td>5.63</td><td>5.98</td><td>0.21</td><td>11.8</td><td>-</td><td>Cubic</td><td>3</td><td>222</td><td>177</td><td>159</td><td>1.7</td><td>4.5</td><td>7.8</td><td>0.39</td><td>28</td></tr>
<tr><td>Comparative Example 1</td><td>78.2</td><td>N.D.</td><td>N.D.</td><td>14</td><td>7.9</td><td>1</td><td>0.9</td><td>0.55</td><td>Amorphous (some being cubic)</td><td>&lt;1</td><td>66</td><td>28</td><td>14</td><td>0.4</td><td>0.9</td><td>1.8</td><td>3.3</td><td>-</td></tr>
<tr><td colspan="21">R: Ratio of (2Θ=22-24° Peak Intensity) / (2Θ=30.8-33.2° Peak Intensity)</td></tr>
</table>

Table 2 lists the shape and the size of the particles of the Examples and the Comparative Example as determined from the SEM images.

In the instance where particles with different shapes were recognized to exist, a representative shape (most frequently observed shape) is listed. Aggregates of particles having a cubic shape are classified as particles having a cubic shape. In the instance where no particular shape was observed, the particles were determined to be amorphous.

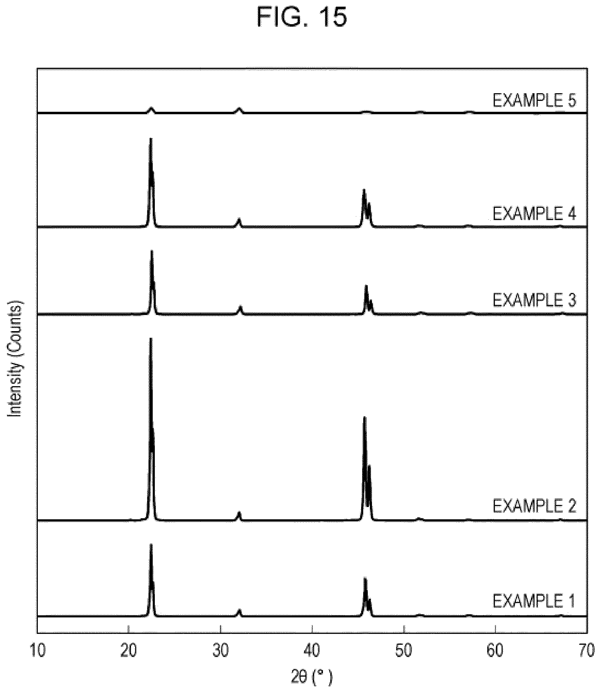

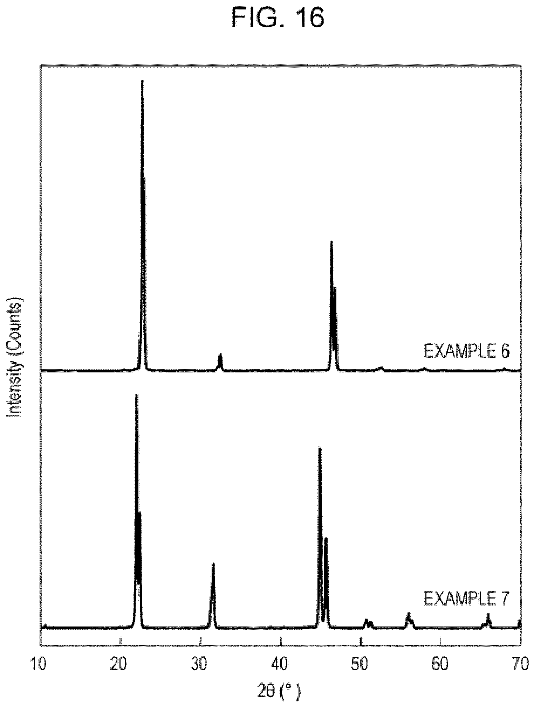

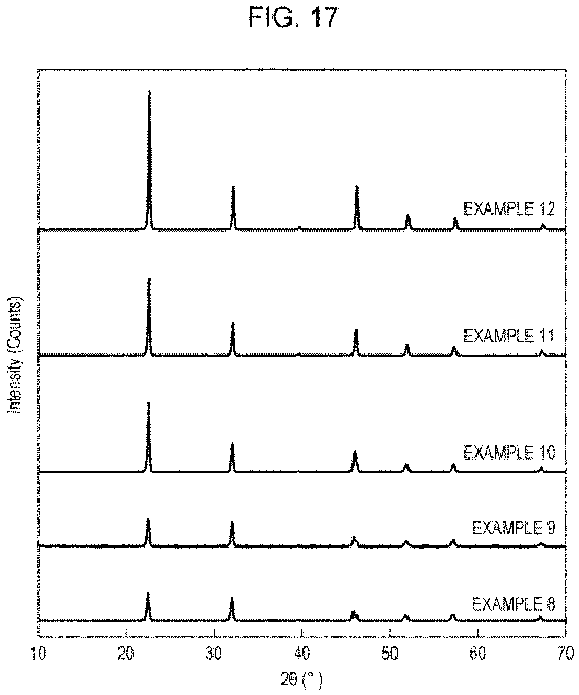

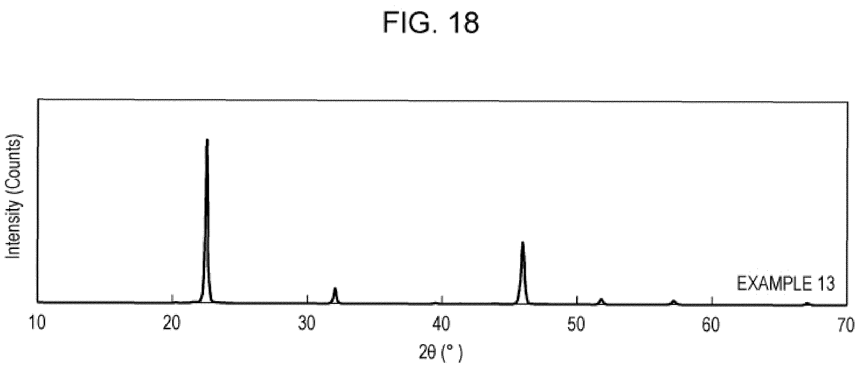

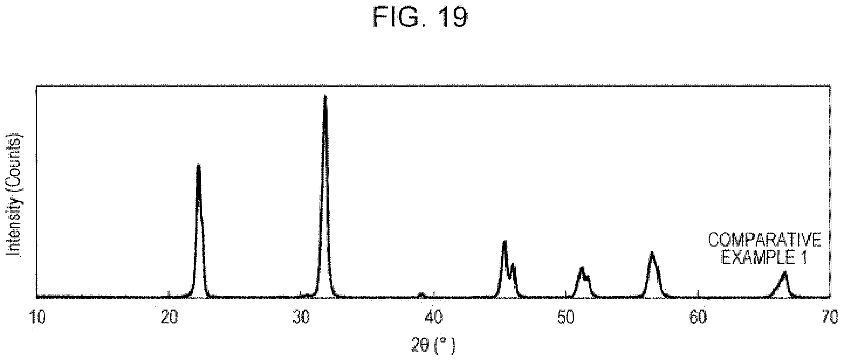

Figs. 15 to 19 show the results of the XRD analysis.

In the samples of Examples 1 to 5, respective peaks were observed at $2\theta=23.0°\pm1.0°$, $2\theta=32.0°\pm1.2°$, and $2\theta=57.0°\pm1.0°$, which correspond to the (100) plane, the (110) plane, and the (221) plane, respectively, of the perovskite structure of $K_xNa_{(1-x)}NbO_3$.

In the sample of Example 6, respective peaks were observed at $2\theta=23.0°\pm1.0°$, $2\theta=32.0°\pm1.2°$, and $2\theta=57.0°\pm1.0°$, which correspond to the (100) plane, the (110) plane, and the (221) plane, respectively, of the perovskite structure of $NaNbO_3$.

In the sample of Example 7, respective peaks were observed at $2\theta=23.0°\pm1.0°$, $2\theta=32.0°\pm1.2°$, and $2\theta=57.0°\pm1.0°$, which correspond to the (100) plane, the (110) plane, and the (221) plane, respectively, of the perovskite structure of $KNbO_3$.

In the samples of Examples 8 to 13, respective peaks were observed at $2\theta=23.0°\pm1.0°$, $2\theta=32.0°\pm1.2°$, and $2\theta=57.0°\pm1.0°$, which correspond to the (100) plane, the (110) plane, and the (221) plane, respectively, of the perovskite structure of $K_xNa_{(1-x)}Nb_yTa_{(1-y)}O_3$.

In the sample of Comparative Example 1, respective peaks were also observed at $2\theta=23.0°\pm1.0°$, $2\theta=32.0°\pm1.2°$, and $2\theta=57.0°\pm1.0°$, which correspond to the (100) plane, the (110) plane, and the (221) plane, respectively, of the perovskite structure of $K_xNa_{(1-x)}NbO_3$.

The results of the SEM observation and the XRD analysis confirmed that the powders prepared in Examples 1 to 13 included $K_xNa_{(1-x)}Nb_yTa_{(1-y)}O_3$ particles having a cubic shape and a perovskite structure.

Regarding the above-mentioned peaks obtained in the X-ray diffraction measurements, the ratio R between the peak intensity I (100) and the peak intensity I (110) was determined, where the peak intensity I (100) was an intensity of the peak having a peak top at $2\theta = 23.0\pm1.0°$, and the peak intensity I (110) was an intensity of the peak having a peak top at $2\theta = 32.0\pm1.2°$. R = I(100)/I(110)

The peak intensities that were employed were each the value at the peak top of the peak of interest.

The values of R are shown in Table 2. As is apparent from the results shown in Figs. 15 to 19, the values of R in Examples 1 to 13 were greater than or equal to 1, whereas the value of R in Comparative Example 1 was 0.9, which was lower than the values of the Examples.

The results of the SEM observation confirmed that the powder sample of Comparative Example 1 contained amorphous particles. In Comparative Example 1, presumably, since the proportion of amorphous particles was large, it was unlikely that the particles were oriented in a uniform direction during the XRD measurement, and, consequently, diffractions from the (110) plane were more frequently detected than diffractions from the (100) plane.

Thus, the powders prepared in Examples 1 to 13, in which the value of R was greater than or equal to 1, were demonstrated to be high-quality powders containing large quantities of $K_xNa_{(1-x)}NbO_3$ particles that had high uniformity in shape of the particles.

Furthermore, it was demonstrated that the powder samples of Examples 1 to 13 contained niobium, tantalum, molybdenum, potassium, and sodium in the amounts shown in Table 2, which were calculated as oxides from the amounts determined by the XRF analysis.

Focus is now directed to the particle sizes (SEM observation, $D_{50}$) and the crystallite size. The particles obtained in Examples 1 to 13 had a larger primary particle size and a larger crystallite size than the particles obtained in the Comparative Example. Presumably, this is because large portions of the raw material compounds, namely, $MoO_3$, $Na_2Co_3$, and $K_2CO_3$ (including products and decomposition products derived therefrom), used in the production method of each of the Examples, acted as fluxing agents, thereby enabling favorable progression of the crystal growth of the particles.

Furthermore, the higher the firing temperature, the more likely it was that particles with a larger size were obtained (Examples 1 to 5).

It was confirmed that the particles of Examples 1 to 13 and Comparative Example 1 had the BET specific surface area shown in Table 2.

The results of Examples 1 to 13 demonstrated that by performing the firing of a niobium compound or of a niobium compound and a tantalum compound in the presence of a potassium compound and/or a sodium compound, it was possible to produce, by firing, $K_xNa_{(1-x)}Nb_yTa_{(1-y)}O_3$ particles having a high value of the average crystallite size, having a perovskite structure, and being of high quality.

In each of Examples 1 to 12, in which a molybdenum compound was used, a percent yield was greater than or equal to 80 mass%, where the percent yield was calculated as the actual yield of the $K_xNa_{(1-x)}Nb_yTa_{(1-y)}O_3$ particles/the theoretical yield $\times$ 100 (mass%). In contrast, in Example 13, in which no molybdenum compound was used, the percent

yield of the $K_xNa_{(1-x)}Nb_yTa_{(1-y)}O_3$ particles was 28 mass%.

Thus, it was demonstrated that with the use of a molybdenum compound, $K_xNa_{(1-x)}Nb_yTa_{(1-y)}O_3$ particles could be produced with high efficiency.

<2. Production of Resin Composition>

2.1. Production of $K_xNa_{(1-x)}NbO_3$ Particles

[Example 14]

A mixture was prepared by mixing 40.3 g of niobium oxide ($Nb_2O_5$, manufactured by Kanto Chemical Co., Inc.), 27.21 g of molybdenum oxide ($MoO_3$, manufactured by Nippon Inorganic Colour & Chemical Co., Ltd.), x=8.0 g of sodium carbonate ($Na_2CO_3$, manufactured by Kanto Chemical Co., Inc.), and 46.1 g-x g of potassium carbonate ($K_2CO_3$, manufactured by Kanto Chemical Co., Inc.) together in an absolute mill (manufactured by Osaka Chemical Co., Ltd.) for 30 seconds. Portions of the resulting mixture were loaded into four alumina crucibles and fired in a ceramic electric furnace at 900°C for 10 hours.

Subsequently, ultrasonic cleaning was performed four times. In the ultrasonic cleaning, the resulting fired product was placed in 250 mL of purified water, treated in an ultrasonic cleaning machine for 10 minutes, thereafter allowed to stand for 30 minutes, and then subjected to decantation. The resultant was dried to afford a powder of Example 14.

The synthesis conditions are shown in Table 3.

[Table 3]

| | Synthesis | | | | | | | | | |
|---|---|---|---|---|---|---|---|---|---|---|
| | Raw Materials | | | | | Amount of Fluxing Agents* | (K+Na)/ (Nb+Ta) | (K+Na)/ Mo | K/Na | Firing Conditions |
| | $Nb_2O_5$ | $Ta_2O_5$ | $MoO_3$ | $K_2CO_3$ | $Na_2CO_3$ | | | | | |
| | g | g | g | g | g | parts by mass | molar ratio | molar ratio | molar ratio | °C |
| Example 14 | 40.3 | - | 27.21 | 38.1 | 8 | 181.9 | 2.32 | 1.86 | 3.7 | 900 |
| Example 15 | 40.3 | - | 27.21 | 34.1 | 12 | 181.9 | 2.38 | 1.90 | 2.2 | 900 |
| Example 16 | 40.3 | - | 27.21 | 30.1 | 16 | 181.9 | 2.43 | 1.95 | 1.4 | 900 |
| Example 17 | 40.3 | - | 27.21 | 26.1 | 20 | 181.9 | 2.49 | 2.00 | 1.0 | 900 |
| Comparative Example 1 | - | - | - | - | - | - | - | - | - | - |
| * Total parts by mass of $MoO_3$, $K_2CO_3$, and $Na_2CO_3$ per 100 parts by mass of the total mass of $Nb_2O_5$ and $Ta_2O_5$ | | | | | | | | | | |

[Examples 15 to 17]

Powders of Examples 15 to 17 were prepared by performing the same operation as that of Example 14, except that the proportions of the raw material compounds and the firing temperature were changed from those of Example 14 as shown in Table 3.

<Results>

The results of the evaluations described above are shown in Table 4. The symbol "-" indicates that the compound was not used. "N.D." is an abbreviation of "not detected" and indicates that the compound was not detected.

[Table 4]

| | $K_xNa_{1-x}Nb_yTa_{1-y}O_3$ | | | | | | | | | | | | | | | |
|---|---|---|---|---|---|---|---|---|---|---|---|---|---|---|---|---|
| | Evaluations | | | | | | | | | | | | | | | |
| | XRF | | | | | | XRD | | SEM | | Crystallite Size | | | Particle Size | | | BET |
| | $Nb_2O_5$ | $Ta_2O_5$ | $MoO_3$ | $K_2O$ | $Na_2O$ | y | R | x by XRD | Shape | Size | 22-24° | 30.8-33.2° | 56-58° | D10 | D50 | D90 | Specific Surface Area |
| | mass % | mass % | mass % | mass % | mass % | | | | | μm | nm | nm | nm | μm | μm | μm | m²/g |
| Example 14 | 82.2 | N.D. | N.D. | 14.7 | 3.1 | 1 | 27 | 0.77 | Cubic | 15 | 308 | 228 | 158 | 6.4 | 12.9 | 23.4 | 0.29 |
| Example 15 | 84.5 | N.D. | N.D. | 10.2 | 5.3 | 1 | 3.9 | 0.43 | Cubic | 15 | 192 | 180 | 149 | 6.5 | 12.5 | 24.5 | 0.29 |
| Example 16 | 86.2 | N.D. | 0.05 | 7.2 | 6.5 | 1 | 3.7 | 0.3 | Cubic | 15 | 307 | 154 | 113 | 6.2 | 12.4 | 26.4 | 0.28 |
| Example 17 | 87.8 | N.D. | 0.06 | 4.1 | 7.9 | 1 | 3.6 | 0.24 | Cubic | 15 | 146 | 175 | 115 | 5.3 | 12.2 | 26.7 | 0.28 |
| Comparative Example 1 | 78.2 | N.D. | N.D. | 14 | 7.9 | 1 | 0.9 | 0.55 | Amorphous (some being cubic) | <1 | 66 | 28 | 14 | 0.4 | 0.9 | 1.8 | 3.3 |
| R: Ratio of (2Θ=22-24° Peak Intensity) / (2Θ=30.8-33.2° Peak Intensity) | | | | | | | | | | | | | | | | | |

The results shown in Table 4 confirmed that the powders prepared in Examples 14 to 17 included $K_xNa_{(1-x)}NbO_3$ particles having a perovskite structure.

2.2. Production of Resin Composition

A polymer solution was prepared by dissolving 30 mass% of a cyanoethylated polyvinyl alcohol (Cyanoresin (registered trademark) CR-V, manufactured by Shin-Etsu Chemical Co., Ltd.) into 70 mass% of N,N-dimethylformamide. 7.33 g of the polymer solution and 13.5 g of the respective powders prepared in Examples 14 to 17 and Comparative Example 1 were placed in respective vials and mixed in a mixer (AwatoriRentaro, manufactured by Thinky) for 2 minutes, to afford resin compositions of Examples 15 to 17 and Comparative Example 1.

<Evaluation of Piezoelectric Property>

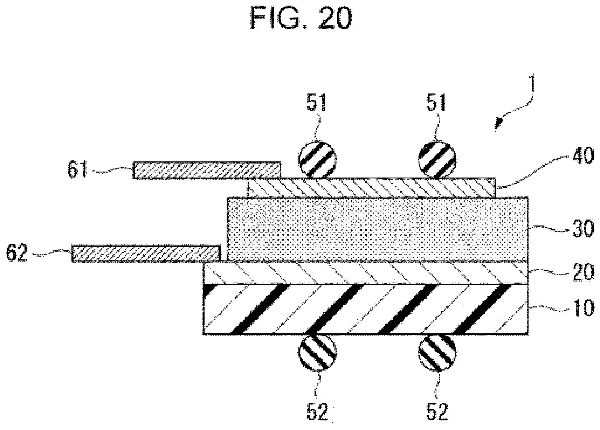

A simple speaker (Fig. 20) was fabricated according to the following procedure, to evaluate a piezoelectric property.

A copper electrode having a thickness of 100 nm was vapor-deposited onto a PET film 10, which had a thickness of 50 $\mu$m, in a vapor deposition apparatus, to form a lower electrode 20.

The resin composition prepared as described above was coated onto the copper electrode to a dry thickness of 50 $\mu$m, with a baker-type applicator (SA-201, manufactured by Tester Sangyo Co., Ltd.), to form a composite layer 30 (molded article of the resin composition). Subsequently, the resultant was dried in a dryer at 80°C for 10 minutes. Note that in the operation of coating, a portion of the copper electrode was covered with masking tape, with another portion of the copper electrode being exposed.

A polarization treatment was performed as follows, using a corona discharge system (ELC-01N type, manufactured by Element Co., Ltd.). After the copper electrode was grounded, the multilayer body prepared as described above was heated to 100°C, and a voltage of -7 kV was applied to a surface of the composite layer 30.

The exposed portion of the lower electrode 20 and a peripheral portion of the composite layer were masked with Kapton tape, and an Al electrode was vapor-deposited onto a region slightly smaller than the region of the composite layer 30 to form an upper electrode 40.

In the resulting multilayer body, in which the PET film 10 (50 $\mu$m), the lower electrode 20 (Cu, 100 nm), the composite layer 30 (50 $\mu$m), and the upper electrode 40 (Al, 100 nm) were layered in this order, conductive tape 61 and 62 (CU-35C, copper foil, manufactured by 3M) was attached to the lower electrode 20 and the upper electrode 40. Subsequently, the multilayer body was held with O-rings 51, 52, and the composite layer was bent.

A voltage of 1 kHz and 20 Vpp was applied via conductive tape 61 and 62, which was held with alligator clips, and a sound pressure (a relative value with respect to the value of Comparative Example 1 taken as 1) was obtained at a position 2 cm away from the composite layer. The sound pressure was measured with a microphone (4152N, manufactured by Aco Co., Ltd.).

The results are shown in Table 5. The molar ratio denoted as K/(K+Na), shown in Table 5, was calculated from the content percentages (mass%) calculated as $K_2O$ and $Na_2O$ shown in Table 4, which were calculated based on the XRF analysis.

[Table 5]

|  | K/(K+Na) | Crystallite Size (2Θ=22-24°) | Sound Pressure |
|---|---|---|---|
|  | molar ratio | nm |  |
| Example 14 | 0.77 | 308 | 20 |
| Example 15 | 0.43 | 192 | 40 |
| Example 16 | 0.3 | 307 | 25 |
| Example 17 | 0.24 | 146 | 15 |
| Comparative Example 1 | 0.55 | 66 | 1 |

The speakers including the respective composite layers, which contained the respective powders of Examples 14 to 17, had a very high value of the sound pressure compared to the speaker including the composite layer containing the powder of Comparative Example 1. Thus, it was found that the composite layers containing the powders of Examples 14 to 17 had an excellent piezoelectric effect.

Presumably, the improvement in the sound pressure was due to an excellent piezoelectric property that was exhibited as a result of the fact that the crystallite size of the $K_xNa_{(1-x)}NbO_3$ particles included in the powders of Examples 14 to 17 was larger than the crystallite size of the $K_xNa_{(1-x)}NbO_3$ particles included in the powder of Comparative Example 1.

A comparison between Comparative Example 1 and Example 15, which had x values (values of K/(K+Na)) that were similar, reveals, for example, that the crystallite size of the $K_xNa_{(1-x)}NbO_3$ particles included in the powder of Example 15, as determined from the peak at $2\theta = 23.0 \pm 1.0°$, was larger than the crystallite size of the powder of Comparative Example 1.

In addition, presumably, as indicated by the high value of the ratio R between the peak intensities, the fact that the powders of Examples 14 to 17 included large quantities of $K_xNa_{(1-x)}NbO_3$ particles that had uniformity in shape of the particles and were, therefore, of high quality also contributed to the excellent piezoelectric property that was exhibited.

The constituents, combinations thereof, and the like in the embodiments are merely illustrative. Addition, omission, and/or substitution of one or more constituents as well as other modifications may be made without departing from the spirit of the present invention. Furthermore, the present invention is not limited to the embodiments and is only limited by the scope of the claims.

Reference Signs List

1... speaker, 10... film, 20...lower electrode, 30...composite layer, 40 ... upper electrode, 51, 52...0-ring, 61,62...conductive tape

## Claims

1. Niobate particles comprising a crystal structure of niobate represented by $K_xNa_{(1-x)}Nb_yTa_{(1-y)}O_3$, where $0 \leq x \leq 1$, and $0 < y \leq 1$, wherein
   the crystal structure has an average crystallite size of 80 nm or greater as determined from a peak at $2\theta = 23.0 \pm 1.0°$ of the niobate, the peak being a peak obtained in an X-ray diffraction measurement.

2. The niobate particles according to Claim 1, wherein the crystal structure comprises a perovskite crystal structure.

3. The niobate particles according to Claim 1 or 2, wherein the niobate particles have a cubic shape.

4. The niobate particles according to Claim 1 or 2,
   wherein the crystal structure has an average crystallite size of 50 nm or greater as determined from a peak at $2\theta = 32.0 \pm 1.2°$ of the niobate, the peak being a peak obtained in an X-ray diffraction measurement.

5. The niobate particles according to Claim 1 or 2,
   wherein the niobate particles have a particle size $D_{50}$ of 0.1 to 100 $\mu$m as calculated by a laser diffraction light scattering method.

6. The niobate particles according to Claim 1 or 2,
   wherein a ratio R between a peak intensity I (100) and a peak intensity I (110) is 1 or greater, where the peak intensity I (100) is an intensity of the peak at $2\theta = 23.0 \pm 1.0°$ of the niobate, and the peak is obtained in the X-ray diffraction measurement, and where the peak intensity I (110) is an intensity of a peak at $2\theta = 32.0 \pm 1.2°$ of the niobate, and the peak is obtained in an X-ray diffraction measurement.

$$R = I(100)/I(110)$$

7. The niobate particles according to Claim 1 or 2, wherein, in the niobate particles, a total content of niobium or of niobium and tantalum, in terms of a total content percentage calculated as $Nb_2O_5$ and $Ta_2O_5$, is 50 to 99 mass% as determined by an XRF analysis of the niobate particles, the total content percentage being based on a total mass of the niobate particles taken as 100 mass%.

8. The niobate particles according to Claim 1 or 2, wherein, in the niobate particles, a content of potassium and/or sodium, in terms of a total content percentage calculated as $K_2O$ and $Na_2O$, is 0.5 to 40 mass% as determined by an XRF analysis of the niobate particles, the total content percentage being based on a total mass of the niobate particles taken as 100 mass%.

9. The niobate particles according to Claim 1 or 2, further comprising molybdenum.

10. The niobate particles according to Claim 9, wherein, in the niobate particles, a content of the molybdenum, in terms of a content percentage calculated as $MoO_3$, is 0.01 to 20 mass% as determined by an XRF analysis of the niobate particles, the content percentage being based on a total mass of the niobate particles taken as 100 mass%.

11. A method for producing niobate particles, which is a method for producing the niobate particles according to Claim 1, the method comprising firing a niobium compound or firing a niobium compound and a tantalum compound, in the presence of a potassium compound and/or a sodium compound.

12. The method for producing niobate particles according to Claim 11, wherein the sodium compound is sodium carbonate, and the potassium compound is potassium carbonate.

13. The method for producing niobate particles according to Claim 11, which is a method for producing the niobate particles according to Claim 9, the method comprising firing the niobium compound or firing the niobium compound and the tantalum compound, in the presence of a molybdenum compound and of the potassium compound and/or the sodium compound.

14. The method for producing niobate particles according to Claim 13, wherein the molybdenum compound is at least one compound selected from the group consisting of molybdenum trioxide, potassium molybdate, and sodium molybdate.

15. The method for producing niobate particles according to Claim 11 or 12, the method comprising:

    a step of mixing the niobium compound, or the niobium compound and the tantalum compound, with the potassium compound and/or the sodium compound to form a mixture; and
    a step of firing the mixture, wherein
    a molar ratio of potassium atoms and sodium atoms to niobium atoms and tantalum atoms in the mixture, which is a molar ratio denoted as (K+Na)/(Nb+Ta), is 1.1 or greater.

16. A resin composition comprising:

    the niobate particles according to Claim 1 or 2; and
    a resin.

17. A molded article molded from the resin composition according to Claim 16.

## FIG. 1

EXAMPLE 1

## FIG. 2

EXAMPLE 2

FIG. 3

EXAMPLE 3

FIG. 4

EXAMPLE 4

FIG. 5

EXAMPLE 5

FIG. 6

EXAMPLE 6

FIG. 7

EXAMPLE 7

FIG. 8

EXAMPLE 8

FIG. 9

EXAMPLE 9

FIG. 10

EXAMPLE 10

FIG. 11

EXAMPLE 11

FIG. 12

EXAMPLE 12

# FIG. 13

EXAMPLE 13

# FIG. 14

COMPARATIVE EXAMPLE 1

## FIG. 15

## FIG. 16

# FIG. 17

FIG. 18

EXAMPLE 13

2θ (°)

Intensity (Counts)

FIG. 19

FIG. 20

## INTERNATIONAL SEARCH REPORT

| | International application No. |
|---|---|
| | **PCT/JP2023/015590** |

**A. CLASSIFICATION OF SUBJECT MATTER**

*C01G 33/00*(2006.01)i; *C01G 35/00*(2006.01)i
FI: C01G33/00 A; C01G35/00 C

According to International Patent Classification (IPC) or to both national classification and IPC

**B. FIELDS SEARCHED**

Minimum documentation searched (classification system followed by classification symbols)

C01G33/00; C01G35/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JSTChina/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | JP 2005-272266 A (TOYOTA CENTRAL RES & DEV LAB INC) 06 October 2005 (2005-10-06) claims, paragraphs [0024]-[0028], [0112]-[0125], fig. 1-13 | 1-6, 11, 12, 15 |
| Y | | 16, 17 |
| A | | 7-10, 13, 14 |
| X | JP 2012-246178 A (CANON INC, UNIV OF YAMANASHI) 13 December 2012 (2012-12-13) claims, paragraphs [0001], [0024]-[0026], [0090]-[0112], fig. 1-7 | 1-8 |
| Y | | 16, 17 |
| X | JP 2018-115093 A (SAMSUNG ELECTRO MECH) 26 July 2018 (2018-07-26) claims, paragraphs [0002], [0092]-[0110], fig. 1, 2 | 1-6 |
| Y | | 16, 17 |
| Y | JP 2022-12827 A (JNC CORP) 17 January 2022 (2022-01-17) claims, paragraph [0025] | 16, 17 |

☐ Further documents are listed in the continuation of Box C.　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 July 2023** | **18 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/015590**

| Patent document cited in search report | | | Publication date (day/month/year) | Patent family member(s) | Publication date (day/month/year) |
|---|---|---|---|---|---|
| JP | 2005-272266 | A | 06 October 2005 | (Family: none) | |
| JP | 2012-246178 | A | 13 December 2012 | US 2014/0106170 A1 claims, paragraphs [0002], [0037]-[0040], [0116]-[0137], fig. 1-7 WO 2012/165267 A1 CN 103732539 A KR 10-2014-0025521 A | |
| JP | 2018-115093 | A | 26 July 2018 | (Family: none) | |
| JP | 2022-12827 | A | 17 January 2022 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022070229 A

- JP 2020145408 A

**Non-patent literature cited in the description**

- **BO-PING ZHANG et al.** *J. Am. Ceram. Soc.*, 2006, vol. 89 (5), 1605-1609